# EUROPEAN PATENT SPECIFICATION

(11) **EP 2 725 621 B1**
(45) Date of publication and mention of the grant of the patent: **18.04.2018**
(21) Application number: 13153877.9
(22) Date of filing: 04.02.2013
(51) Int. Cl.: H01L 29/49, H01L 29/786, H01L 27/12

(54) **Array substrate and method for manufacturing the same and display device**
Arraysubstrat und Verfahren zu seiner Herstellung und Anzeigevorrichtung
Substrat de réseau et son procédé de fabrication et dispositif d'affichage

(30) Priority: 26.10.2012 CN 201210418592; 30.11.2012 CN 201210506159
(43) Date of publication of application: 30.04.2014
(73) Proprietor: BOE Technology Group Co., Ltd., Beijing 100015 (CN)
(72) Inventor: Yuan, Guangcai, Beijing 100176 (CN); Lee, Woobong, Beijing 100176 (CN)
(74) Representative: Klunker IP Patentanwälte PartG mbB

(56) References cited:
- US-A- 5 831 708
- US-A- 6 100 954
- US-A1- 2011 127 518
- US-A1- 2011 163 311
- US-A1- 2012 082 941

## Description

### TECHNICAL FIELD

Embodiments of the present invention relate to an array substrate and a display device.

### BACKGROUND

Oxide thin film transistors (TFTs) are such kind of thin film transistors that employ metal oxide semiconductors for active layers, and have such advantages as ultrathin profile, low power consumption, etc. They can not only be useful in manufacture of a liquid crystal display panel, but also can be used for a new generation of organic light-emitting diode (OLED) display panels.

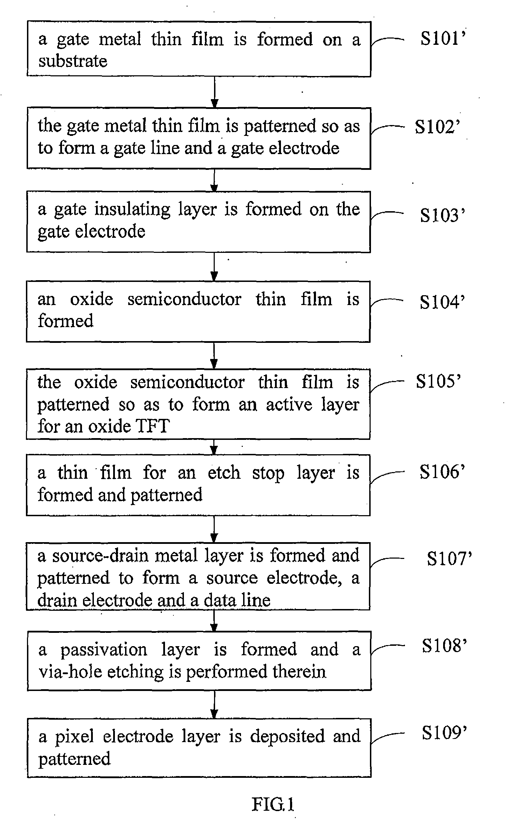

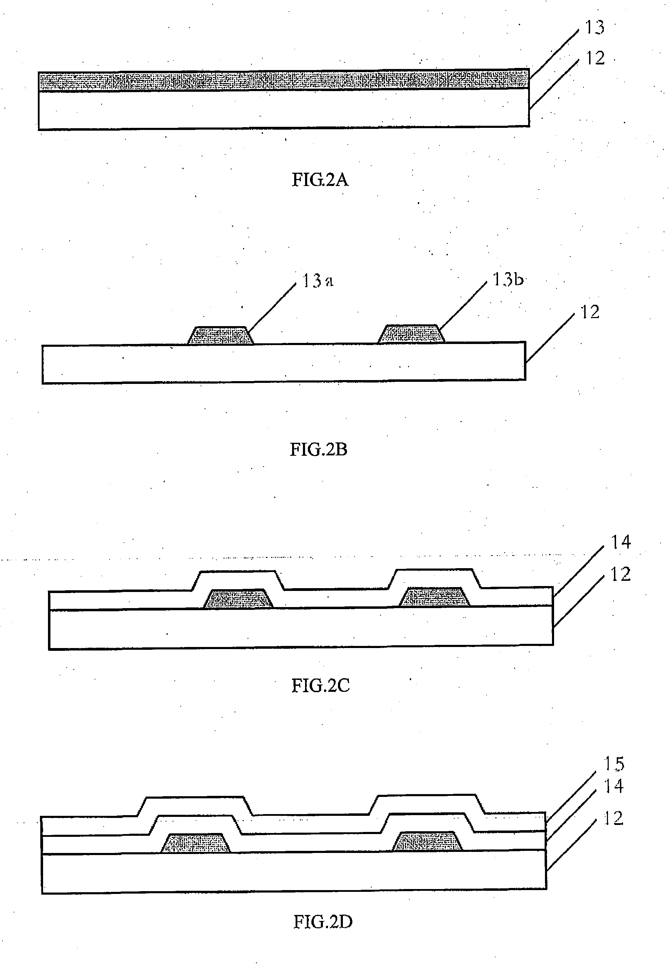

Referring to FIG. 1 and FIGs.2A to 2M, a method for manufacturing an oxide TFT array substrate in prior art will be described below.

FIG. 1 is a flow chart illustrating the method for manufacturing the oxide TFT array substrate in prior art, and FIGs. 2A to 2M are cross-sectional views in the course of manufacturing the oxide TFT array substrate.

S101'; a gate metal thin film is formed on a substrate.

As shown in FIG 2A, a gate metal thin film 13 is formed on a substrate 12. During manufacture of TFTs, gate metal thin films are mostly manufactured by means of magnetron sputtering, and materials for them can be selected according to different device structures and process requirements. The substrate 12 may be a glass substrate, a quartz substrate or other transparent substrate of an inorganic material, or may also be a transparent substrate produced by using an organic flexible material.

S102', the gate metal thin film is patterned so as to form a gate line and a gate electrode.

As shown in FIG 2B, by means of wet etching, the gate metal thin film 13 is patterned so as to obtain a gate line (not shown in the figure), a gate electrode 13a, and a common electrode line 13b. The common electrode line may not be produced depending on a specific design.

S103', a gate insulating layer is formed on the gate electrode.

As shown in FIG 2C, after patterning of the gate electrode, through a pre-clean process (cleaning before film formation), a plasma enhanced chemical vapor deposition (PECVD) and so on, a gate insulating layer 14 is produced on the substrate formed with the gate pattern.

S104', an oxide semiconductor thin film is formed.

As shown in FIG 2D, an oxide semiconductor thin film 15 is formed. A very key stage for manufacture of oxide TFTs is manufacture of an oxide semiconductor thin film. The widely used oxide semiconductors at present include indium gallium zinc oxide (IGZO), indium gallium tin oxide (IGTO), indium zinc oxide (IZO) and so on, and compositions related to these materials in other different stoichiometries. The main manufacturing methods comprise a magnetron sputtering deposition, a solution method, etc.

S105', the oxide semiconductor thin film is patterned so as to form an active layer for an oxide TFT.

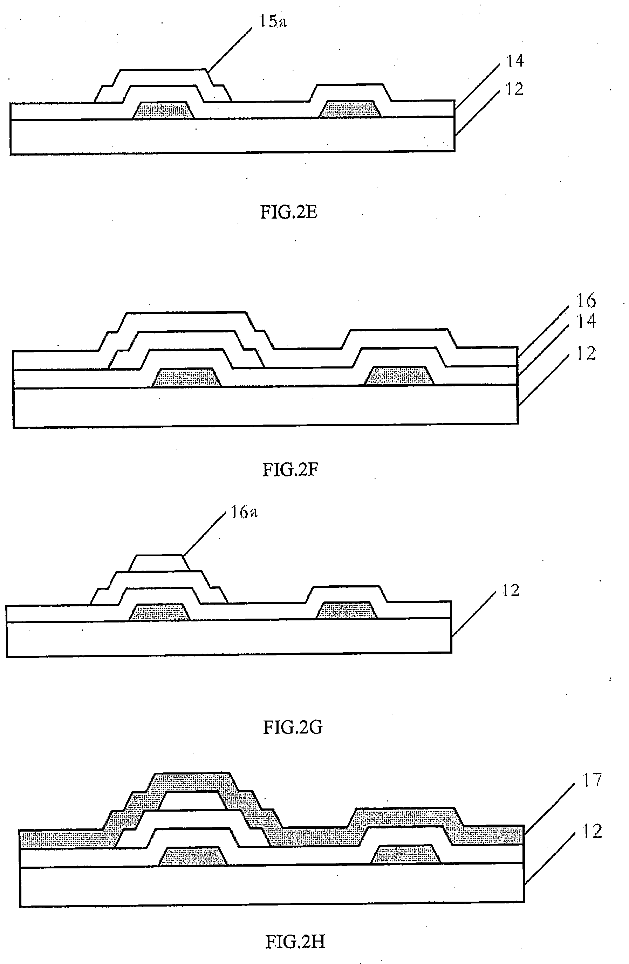

As shown in FIG 2E, the oxide semiconductor thin film is patterned so as to attain the pattern of an active layer 15a. For the patterning process of an active-layer oxide semiconductor, there are two main etching processes, i.e., one is a wet etching process, and the other is a dry etching process. However, use of different methods will cause different damages to the oxide semiconductor layer.

S106', a thin film for an etch stop layer is formed and patterned.

As shown in FIG 2F, a thin film 16 for an etch stop layer (ESL) is formed for reducing the damages to the active layer formed from oxide semiconductor in the course of the subsequent patterning of a data line. After formation of the thin film for the etch stop layer, a patterning is carried out so as to form an etch stop layer 16a, as shown in FIG 2G.

S107', a source-drain metal layer is formed and patterned to form a source electrode, a drain electrode and a data line.

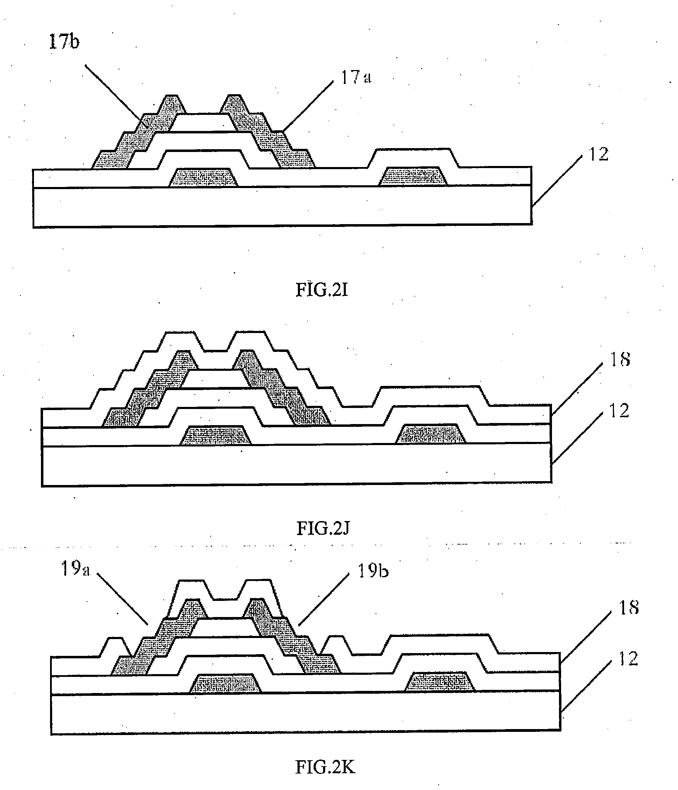

As shown in FIG. 2H, during manufacturing process of a LCD, firstly, a source-drain metal layer 17 is deposited, and then is patterned by means of wet etching, and next a source electrode 17b, a drain electrode 17a (as shown in FIG 2I) and a data line (not shown in the figure) integrally formed with the source electrode 17b are formed.

During manufacturing process of an OLED, a source electrode, a drain electrode and a power supply line integrally formed with or connected to the source electrode are formed after a source-drain metal layer is patterned in this step.

S108', a passivation layer is formed and a via-hole etching is performed therein.

As shown in FIG 2J, after patterning of the data line or the power supply line, a passivation layer 18 is formed on the whole plane. After formation of the passivation layer, a via-hole etching is carried out to form a via hole 19b for realizing connection of the drain electrode 17a to a pixel electrode, as shown in FIG. 2K. Furthermore, during the etching, a via hole may also be formed over the source electrode 17b so as to connect the source electrode 17b with a signal access terminal, such as the data line or power supply line produced on a different layer as the source electrode 17b.

S109', a pixel electrode layer is deposited and patterned.

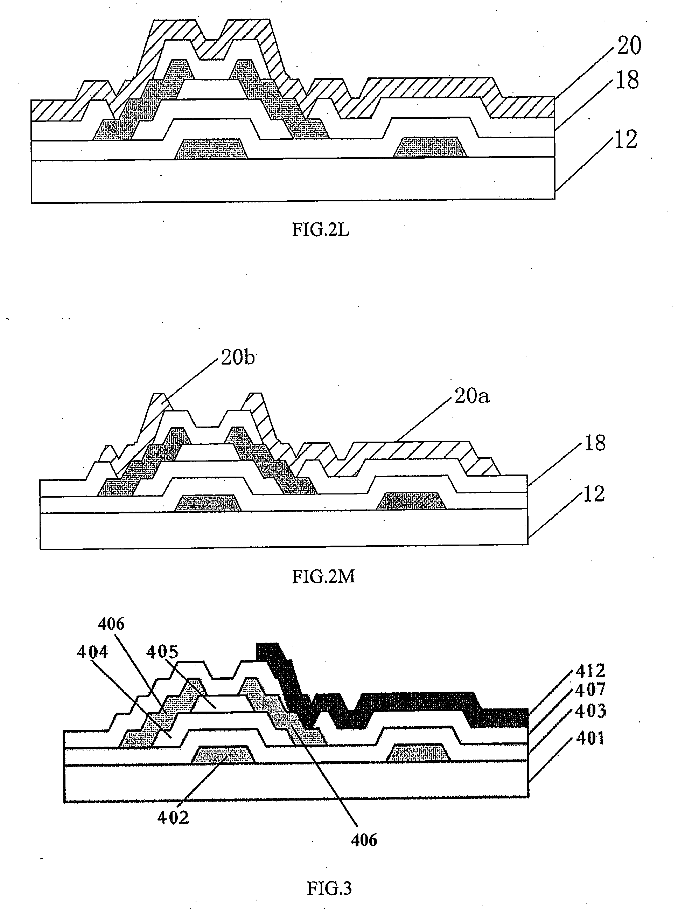

As shown in FIG 2L, after formation of the via holes, a pixel electrode layer 20, for which indium tin oxide (ITO) material is now widely adopted, is formed, and is patterned by means of wet etching so as to form a pixel electrode 20a and a contact electrode 20b, as shown in FIG 2M.

During the above-mentioned manufacturing process of the array substrate, hydrogen-containing groups, such as OH- and H+, are not possibly avoided from being doped in the passivation layer or hydrogen elements are absorbed in the manufacturing process of the passivation layer. These hydrogen-containing groups are easily broken during manufacture of the device and in the state that the device operates, and are probably diffused into the oxide semiconductor layer as the time goes by and the environment changes. The diffused substances such as OH-, H2O, H+ and the like will disadvantageously affect stability of the device, so that a relatively large drift happens to the threshold voltage Vth of an oxide thin film transistor device, and even malfunction of the product may occur.

US 2011/0127518 A1 discloses a transistor including a passivation layer on a channel layer, a source, a drain, and a gate, wherein the passivation layer is a multi-layer structure including a silicon oxide layer, a silicon oxynitride layer, and a silicon nitride layer sequentially stacked, and wherein the channel layer includes an oxide semiconductor.

US 5 831 708 A discloses an active matrix substrate having a TFT in the vicinity of the intersection of a gate line and a source line and a pixel electrode connected to the TFT, on which an inter-layer insulating film is formed by an acrylic resin between the pixel electrode and the gate line, source line and TFT. The adhesion between the inter-layer insulating film and the pixel electrode is improved by roughening the surface of the inter-layer insulating film by ashing in oxygen plasma, in which water and carbon dioxide are removed by the oxidative destruction of an organic material.

US 2012/0082941 A1 discloses an organic passivation film having a high transmittance and capable of setting a taper angle of a through hole within a predetermined range in a liquid crystal display device.

US 6 100 954 A, which is considered to be the closest prior art, discloses a TFT substrate for a LCD including a substrate; a TFT over the substrate, the TFT having a gate, a source, a drain, a semiconductor layer, and a gate insulation layer; and a protection film over the TFT, the protection film including at least one of fluorinated polyimide, Teflon, cytop, fluoropolyarylether, Fluorinated parylene, PFCB, and BCB.

### SUMMARY

It is an object of the present invention to provide an array substrate, and a display device, which may overcome the problems in existing array substrates that doped hydrogen groups tend to destroy stability of the device and adversely affect yield of products.

The object is solved by means of the features of independent claim 1. Further embodiments and developments are defined in the dependent claims.

### BRIEF DESCRIPTION OF THE DRAWINGS

In order to illustrate the technical solutions of the embodiments of the invention more clearly, the drawings of the embodiments will be briefly described in the following; it is obvious that the drawings described below are only related to some embodiments of the invention and thus are not limitative of the invention.
FIG. 1 is a flow chart showing a method for manufacturing an oxide thin film transistor array substrate in prior art;
FIGs. 2A to 2M are the first to thirteenth schematic views showing the manufacture of the oxide thin film transistor array substrate in prior art, respectively;
FIG. 3 is a structurally schematic view showing an array substrate according to a first example for better understanding of the invention;
FIG. 4 is a flow chart showing a method for manufacturing the array substrate according to the first example for better understanding of the invention;
FIG. 5 is a structurally schematic view showing an array substrate according to a third example for better understanding of the invention;
FIG. 6 is an another schematic view showing the structure of the array substrate according to the third example for better understanding of the invention;
FIG. 7 is a flow chart showing a method for manufacturing the array substrate according to the third example for better understanding of the invention;
FIG. 8 is a structurally schematic view showing an array substrate according to a fifth example for better understanding of the invention;
FIG. 9 is a flow chart showing a method for manufacturing the array substrate according to the fifth example for better understanding of the invention;
FIG. 10 is a structurally schematic view showing an array substrate according to a seventh example for better understanding of the invention;
Fig.11 is a flow chart showing a method for manufacturing the array substrate according to the seventh example for better understanding of the invention;
FIG 12 is a structurally schematic view showing an array substrate according to an embodiment of the invention; and
FIG 13 is a flow chart showing a method for manufacturing the array substrate according to the embodiment of the invention.

### DETAILED DESCRIPTION

In order to make objects, technical details and advantages of the embodiment of the invention apparent, the examples for better understanding of the invention and the technical solution of the embodiment will be described in a clearly and fully understandable way in connection with the drawings related to examples for better understanding of the invention and the embodiment of the invention.

Unless otherwise defined, all the technical and scientific terms used herein should have the same meanings as commonly understood by one of ordinary skill in the art to which the present invention belongs. The terms "first," "second," etc., which are used in the description and the claims of the present application for invention, are not intended to indicate any sequence, amount or importance, but distinguish various components. Also, the terms such as "a," "an," "the," etc., are not intended to limit the amount, but indicate the existence of at least one. The terms "comprises," "comprising," "includes," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "On," "under," "right," "left" and the like are only used to indicate relative position relationship, and when the position of the object which is described is changed, the relative position relationship may be changed accordingly.

In the following described examples for better understanding of the invention and embodiments and the corresponding accompanying drawings, array substrates of twisted nematic (TN) mode LCD are described as examples to introduce an improved technical solution provided by the invention, but the present invention is not limited thereto.

An array substrate according to the example for better understanding of the invention and the embodiments of the invention, for example, comprises a plurality of gate lines and a plurality of data lines, and these gate lines and data lines intersect each other to thereby define pixel units arranged in an array; each of the pixel units may include a thin film transistor functioning as a switch element and a pixel electrode. For example, for the thin film transistor of each of the pixel units, its gate electrode is electrically connected to or integrally formed with a corresponding gate line, its source electrode is electrically connected to or integrally formed with a corresponding data line, and its drain electrode is electrically connected to or integrally formed with the corresponding pixel electrode. The following descriptions are mainly made on a single pixel unit or a plurality of pixel units, but other pixel units may be formed in the same way.

### Example 1

As shown in FIG. 3, an array substrate provided in the example 1 for better understanding of the invention has such an array substrate structure in which the gate layer for a thin film transistor is located at the bottom (i.e., a bottom-gate type). The array substrate comprises: a gate electrode 402 located on a substrate 401, a gate insulating layer 403 and an active layer 404 which are located over the gate electrode 402 respectively, a source-drain electrode layer 406, a pixel electrode layer 412 and a passivation layer. The gate insulating layer 403 is located between the gate electrode 402 and the active layer 404; and the passivation layer is located between the source-drain electrode layer 406 and the pixel electrode layer 412. The source-drain electrode layer 406 includes a source electrode, a drain electrode and a data line (or a power supply line) which have been patterned. As the passivation layer is located between the source-drain electrode layer 406 and the pixel electrode layer 412, hydrogen element and complex of hydrogen in the passivation layer and hydrogen element and complex of hydrogen present in the outside environment are easily permeated into the oxide semiconductor active layer through a channel structure between the source electrode and the drain electrode. This may bring about some negative effects on properties of the oxide semiconductor, and in turn, performance of the whole device is affected. Therefore, in the example 1, structure, substance and manufacturing process of the passivation layer is optimized, so that the effects on the whole device caused by hydrogen element and complex of hydrogen in the passivation layer and hydrogen element and complex of hydrogen from the outside environment are reduced to a great extent and then stability of safety of the whole device are enhanced.

The active layer 404 is of an oxide semiconductor, the gate electrode and/or the source and drain electrodes are made of Cu, Cu alloy, or any one of aluminum, chromium, molybdenum, titanium, neodymium and manganese, as well as any alloy of the above metals, and a stacked structure of the above metals. The source and drain electrodes include a source electrode and a drain electrode of the thin film transistor.

In the example 1, the passivation layer is in a single layer structure comprising a first passivation layer 407. The first passivation layer 407 may be an inorganic insulating layer comprising a silicon oxide thin film, a silicon nitride thin film, a silicon oxynitride thin film, an aluminum oxide thin film, a titanium oxide thin film, a zirconium oxide thin film, a tantalum oxide thin film, a barium titanate thin film, a neodymium oxide thin film or other thin film layer of an inorganic insulating material. A thickness of the first passivation layer 407 made from an inorganic insulating material may be 50 nm∼500nm.

When the thickness of the first passivation layer 407 is in the range of 50 nm∼500nm, it can assured that manufacture of the first passivation layer is completed in a shorter time, that is, the production efficiency is guaranteed, while the oxide semiconductor is effectively avoided from being affected by hydrogen-containing groups. If the thickness of the first passivation layer 407 is too thin, it cannot function to avoid the oxide semiconductor from being affected by hydrogen-containing groups; and if the thickness of the first passivation layer is too thick, a longer tact time is needed, causing reduction of the production efficiency.

In addition, the first passivation layer 407 may also be an organic insulating layer comprising a resin insulating film, an acrylic insulating film or other film layer using an organic insulating material. A thickness of the first passivation layer made from an organic insulating material may be 0.5µm∼2.5µm.

When the thickness of the first passivation layer 407 is in the range of 0.5µm∼2.5µm, it can be assured that manufacture of the first passivation layer is completed in a shorter time, that is, the production efficiency is guaranteed, while an effect on the oxide semiconductor caused by hydrogen-containing groups is effectively avoided. If the thickness of the first passivation layer is too thin, it cannot function to avoid the oxide semiconductor from being affected by hydrogen-containing groups; and if the thickness of the first passivation layer is too thick, a longer tact time is needed, causing reduction of the production efficiency.

To ensure better characteristics of the device, in the example 1, an annealing process can be performed on the first passivation layer 407 (i.e., the first passivation layer 407 is a passivation layer subjected to an annealing process), so that the adverse effect on characteristics of the oxide semiconductor caused by hydrogen element and complex of hydrogen in the passivation layer can be reduced and thus the effect of enhancing stability of the device is achieved.

In the example 1, as for the first passivation layer 407, besides a silicon oxide thin film, a silicon nitride thin film, a silicon oxynitride thin film, an aluminum oxide thin film, a titanium oxide thin film, a zirconium oxide thin film, a tantalum oxide thin film, a barium titanate thin film or a neodymium oxide thin film, a thin film formed of another inorganic insulating material whose material characteristics are the same as or similar to each of the above substances may be used as well. Alternatively, besides a resin insulating film or an acrylic insulating film, a thin film formed of another organic insulating material whose material characteristics are the same as or similar to each of the above substances may be used as well.

In practice, because inorganic materials have a lower cost and a longer use lifetime, if requirements on flexible properties of the device are not taken into consideration, the passivation layer may be fabricated by using an inorganic material; because organic materials possess better flexible properties, if it is necessary for the processed device that factors in flexibility are emphasized, the passivation layer may be fabricated by using an organic material.

The structure of the gate insulating layer 403 in the example 1 may be one-layered, two-layered or three-layered. When the gate insulating layer adopts a one-layered structure, it is called as a first gate insulating layer. The first gate insulating layer is a silicon oxide thin film, a silicon nitride thin film, a silicon oxynitride thin film, an aluminum oxide thin film or a titanium oxide thin film. A thickness of the first gate insulating layer may be 50 nm∼500nm.

Certainly, in the example 1, as for the first gate insulating layer, besides a silicon oxide thin film, a silicon nitride thin film, a silicon oxynitride thin film, an aluminum oxide thin film or a titanium oxide thin film, a thin film formed of another inorganic insulating material whose material characteristics are the same as or similar to each of the above substances may be used as well.

To ensure better characteristics of the device, in the example 1, an annealing process can be performed on the first gate insulating layer (i.e., the first gate insulating layer is an insulating layer subjected to an annealing process) so as to reduce the adverse effect on characteristics of the oxide semiconductor caused by hydrogen element and complex of hydrogen in the gate insulating layer.

When the gate insulating layer adopts a two-layered structure, it comprises a first gate insulating layer close to the gate electrode and a second gate insulating layer close to the active layer. The first gate insulating layer may be a silicon nitride thin film or a silicon oxynitride thin film, and the second gate insulating layer may be a silicon oxide thin film, an yttrium oxide thin film or a silicon oxynitride thin film. A thickness of the first gate insulating layer may be 50 nm∼600nm, and a thickness of the second gate insulating layer may be 50 nm∼650nm.

Certainly, in the example 1, as for the first gate insulating layer, besides a silicon nitride thin film or a silicon oxynitride thin film, a thin film formed of another inorganic insulating material whose material characteristics are the same as or similar to each of the above substances may be used as well. As for the second gate insulating layer, besides a silicon oxide thin film, a yttrium oxide thin film or a silicon oxynitride thin film, a thin film formed of another inorganic insulating material whose material characteristics are the same as or similar to each of the above substances may be used as well.

To ensure better characteristics of the device, in the example 1, an annealing process can be performed on the first gate insulating layer (i.e., the first gate insulating layer is an insulating layer subjected to an annealing process), so as to reduce the adverse effect on characteristics of the oxide semiconductor caused by hydrogen element and complex of hydrogen in the gate insulating layer. In the example 1, in order to achieve a better technical effect still further, an annealing process can be performed on the second gate insulating layer also.

Defects produced by the gate electrode can be suppressed by the material of the above first gate insulating layer favorably (especially when Cu or Cu alloy is adopted for the gate electrode). The function of the second gate insulating layer is to realize favorable match with the oxide semiconductor, and achieve the effect of enhancing properties of the device. The material for the second gate insulating layer typically is an oxide insulating layer in most cases, which material has a worse diffusion resistant ability with respect to groups such as H+, OH- and so on, and therefore, after the first gate insulating layer has been produced, an annealing process is preferably performed on the first gate insulating layer so as to reduce the groups such as H+, OH- and so on in the first gate insulating layer, which might be broken and diffused. Thus, the effect of enhancing stability of the device is achieved.

When the gate insulating layer adopts a three-layered structure, it comprises a first gate insulating layer close to the gate electrode, a second gate insulating layer, and a third gate insulating layer close to the active layer, and the second gate insulating layer is located between the first gate insulating layer and the third gate insulating layer. The first gate insulating layer may be a silicon nitride thin film, a silicon oxynitride thin film or the like inorganic insulating thin film; the second gate insulating layer may be a silicon oxynitride thin film or the like inorganic insulating thin film; and the third gate insulating layer may be a silicon oxide thin film, an aluminum oxide thin film, a titanium oxide thin film or the like inorganic insulating thin film.

A thickness of the first gate insulating layer may be 50 nm∼600nm; a thickness of the second gate insulating layer may be 50 nm∼650nm; and a thickness of the third gate insulating layer can be 20 nm∼600nm.

In the example 1, the gate electrode may be made of Cu or Cu alloy, and may also be made of Mo, Mo-Al-Mo alloy, a stacked structure of Mo/Al-Nd/Mo, purified Al or Al alloy, Mo/Nd/Cu, Ti/Cu or the like metal. Of course, use of Cu or Cu alloy for the gate electrode has effects of optimizing the patterning process, enhancing properties of the device, reducing the cost, etc.

In the example 1, as for the first gate insulating layer, besides a silicon nitride thin film or a silicon oxynitride thin film, a thin film formed of another inorganic insulating material whose material characteristics are the same as or similar to each of the above substances may be used as well.

In the example 1, as for the second gate insulating layer, besides a silicon oxynitride thin film, a thin film formed of another inorganic insulating material whose material characteristics are the same as or similar to each of the above substance may be used as well.

In the embodiment, as for the third gate insulating layer, besides a silicon oxide thin film, an aluminum oxide thin film or a titanium oxide thin film, a thin film formed of another inorganic insulating material whose material characteristics are the same as or similar to each of the above substances may be used as well.

In the example 1, the first gate insulating layer adopts a silicon oxide thin film, a silicon oxynitride thin film or the like inorganic insulating material; defects produced in contact with the gate metal (especially when Cu and a Cu alloy is adopted as the gate electrode) can be suppressed well by the material although the direct contact with the oxide semiconductor will cause properties of the oxide semiconductor layer to degrade, thus the first gate insulating layer is disposed to be immediately close to the gate electrode but far away from the active layer. The second gate insulating layer is disposed as an intermediate layer. Because the second gate insulating layer made from a silicon oxynitride thin film or the like inorganic insulating material contains less content of the groups such as H+, OH- and so on per se, and further has a certain ability of penetration resistant with respect to the groups such as H+, OH- and so on, diffusion of the groups such as H+, OH- and so on toward the oxide semiconductor layer can be suppressed well. Thus, an object of enhancing stability of the device can be achieved. Moreover, in order to enhance characteristics of the device to a great extent, the third gate insulating layer is made to be immediately close to the oxide semiconductor, and good match with the oxide semiconductor can be obtained. Thus, an effect of enhancing stability of the device can be attained.

In the example 1, when the passivation layer adopts a single-layered structure, there is no limitation on the structure of the gate insulating layer, which can be a one-layered, two-layered or three-layered structure. The selection of a specific layer structure can be determined according to practical requirements.

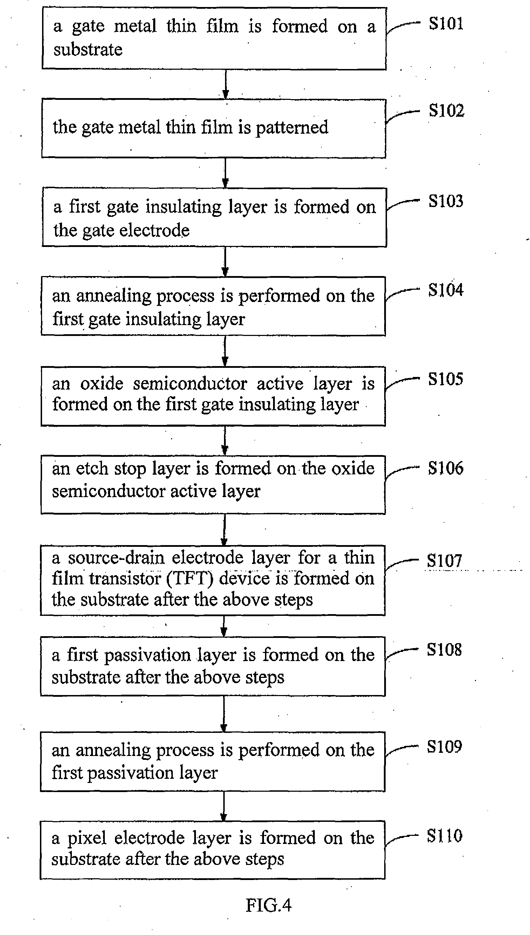

A method for manufacturing the array substrate will be described below by taking as an example a single-layered passivation layer and a single-layered gate insulating layer. In connection with FIG 3 and FIG 4, the example of the method comprises the following steps.

Step S101, a gate metal thin film is formed on a substrate.

For example, a gate metal thin film is formed on a glass substrate 401. The gate metal thin film is usually produced by means of magnetron sputtering, copper or an alloy thereof may be selected as the material for the gate metal film, and its thickness can be 200nm-350nm to keep sheet resistance at a relatively low level.

Step S 102, the gate metal thin film is patterned.

By means of wet etching, the gate metal thin film is patterned so as to form a gate line and a gate electrode 402. Further, if necessary, a common electrode line may be produced simultaneously.

Step S103, a first gate insulating layer is formed on the gate electrode.

The gate insulating layer in the embodiment is in one layer, and silicon oxide thin film, silicon nitride, silicon oxynitride, aluminum oxide, titanium oxide or the like inorganic insulating material may be used to form the first gate insulating layer. A thickness of the first gate insulating layer may be 50nm∼500nm.

Step S 104, an annealing process is performed on the first gate insulating layer.

For example, the annealing process can be optimized: the first gate insulating layer is dehydrogenized with a high-temperature annealing furnace, the annealing is carried out under the protection of nitrogen gas, vacuum, or rare gas, the annealing temperature may be 250°C∼450°C, and the annealing time period may be 20min∼150min.

Or, the annealing process can also be optimized: a vacuum heating chamber is incorporated into a PECVD apparatus, the pressure therein may be 10⁻⁴Pa∼1Pa, and a dehydrogenizing process is performed on the first gate insulating layer; the temperature in the annealing chamber is 350°C∼480°C, and the annealing time period maybe 10 min∼30min.

As the annealing process is an optimized annealing process, for the annealing process the process time period can be shortened, throughput of products can be increased and meanwhile and the investment on the equipment can be reduced, as compared to a conventional annealing process.

Step S105, an oxide semiconductor active layer is formed on the first gate insulating layer.

Indium gallium zinc oxide (IGZO), indium tin zinc oxide (ITZO), indium zinc oxide (IZO) and so on, as well as compositions of the above substances at different ratios, can be used for the oxide semiconductor.

Step S106, after the above active layer of an oxide semiconductor has been produced, an etch stop layer is formed thereon.

Step S107, a source-drain electrode layer for a thin film transistor (TFT) device is formed on the substrate after the above steps. The source electrode and the drain electrode in the source-drain electrode layer 406 contact the two sides of the active layer of an semiconductor layer 404, respectively, and are disposed opposite to each other.

Step S108, a first passivation layer is formed on the substrate after the above steps.

The first passivation layer 407 may be a silicon oxide thin film, a silicon nitride thin film, a silicon oxynitride thin film, an aluminum oxide thin film, a titanium oxide thin film, a zirconium oxide thin film, a tantalum oxide thin film, a barium titanate thin film, a neodymium oxide thin film or the like inorganic insulating material. A thickness of the first passivation layer may be 50 nm∼500nm.

Or, the first passivation layer 407 may be a resin insulating film, an acrylic insulating film or the like organic insulating material. A thickness of the first passivation layer 407 may be 0.5µm∼2.5µm.

Step S109, an annealing process is performed on the first passivation layer.

Because the oxide semiconductor active layer has been produced prior to step the step S109, for the sake of reducing an effect on the active layer caused by the annealing process to a great extent, the temperature adopted by the annealing process in step S109 cannot be too high.

A method of the annealing process may be as follows: a heating chamber, which is vacuumized or filled with air, is incorporated into a PECVD apparatus, and a dehydrogenizing process is performed on the first passivation layer; the temperature in the annealing chamber may be 200°C∼350°C, and annealing time may be 15 min∼90min.

Of course, in addition to the above given conditions for the annealing process, another existing annealing manner may also be selected according to practical circumstances if a dehydrogenizing process can be performed on the first passivation layer.

Step S110, a pixel electrode layer is formed on the substrate after the above steps.

In the example 1, in addition to the layered structure used for the gate insulating layer and/or the passivation layer, the manufacturing processes for other thin films can be implemented with conventional technical means, and they are not design points of this embodiment, and details thereof are omitted here.

Specific materials are selected for the gate insulating layer and the passivation layer in the example 1, it is possible that an adverse effect on the characteristics of the oxide semiconductor, which is caused by doped hydrogen element and complex of hydrogen in the gate insulating layer and the passivation layer as well as in the outside environment, is reduced. The gate metal in the example 1, in addition to Cu and an alloy thereof, may also commonly use Mo, Mo-Al-Mo alloy, a stacked structure of Mo/Al-Nd/Mo, purified Al or Al alloy, Mo/Nd/Cu, Ti/Cu or the like metal.

### Example 2

The example 2 for better understanding of the invention differs from the embodiment 1 in that: the thin film transistor in an array substrate provided in the embodiment has a gate electrode over an active layer (i.e., an array structure of a top-gate type). A structure of a TN type is still described as an example in the example 2, and a passivation layer on the array substrate is located between the gate electrode and a pixel electrode layer. The structure and manufacturing method of the passivation layer are the same as the structure and manufacturing method of the passivation layer in the embodiment 1, and the details thereof are omitted here.

### Example 3

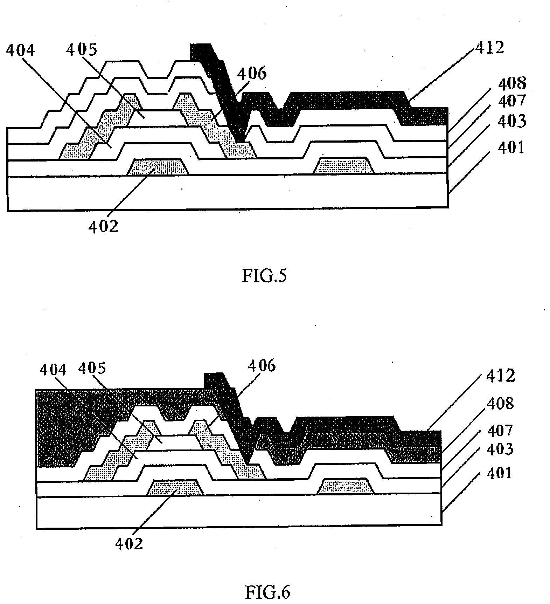

As shown in FIGs. 5 and 6, an array substrate provided in the example 3 for better understanding of the invention has such an array-substrate structure in which a gate electrode of a thin film transistor is at the bottom (i.e., a bottom-gate type).

The array substrate provided in the example 3 comprises: a gate electrode 402 located on a substrate 401, a gate insulating layer 403 and an active layer 404 which are located over the gate electrode 402 respectively, a source-drain electrode layer 406, a pixel electrode layer 412 and a passivation layer. The gate insulating layer 403 is located between the gate electrode 402 and the active layer 404; and the passivation layer is located between the source-drain electrode layer 406 and the pixel electrode layer 412.

The active layer 404 is an oxide semiconductor, and the gate electrode and source and drain electrodes each may be Cu, Cu alloy, aluminum, aluminum alloy, chromium, molybdenum, titanium, neodymium, manganese, or an alloy or a stacked structure of the above metals. The passivation layer has a double-layered structure, comprising a first passivation layer 407 close to the source-drain electrode layer 406 and a second passivation layer 408 close to the pixel electrode layer 412. The first passivation layer 407 is a first inorganic insulating layer, which may comprise a silicon oxide thin film, an aluminum oxide thin film, an yttrium oxide thin film, a zirconium oxide thin film, a tantalum oxide thin film, a barium titanate thin film, a neodymium oxide thin film or a silicon oxynitride thin film. A thickness of the first passivation layer may be 50 nm∼600nm.

The second passivation layer 408 is a second inorganic insulating layer or a first organic insulating layer; the second inorganic insulating layer may comprise a silicon nitride thin film, an yttrium oxide thin film, a silicon oxynitride thin film, a zirconium oxide thin film, a tantalum oxide thin film, a barium titanate thin film or a neodymium oxide thin film; and the first organic insulating layer may comprise a resin insulating film or an acrylic insulating film.

When the second passivation layer is an inorganic insulating layer, the thickness of the second passivation layer may be 50 nm∼500nm; and when the second passivation layer is an organic insulating layer, the thickness of the second passivation layer may be 0.5µm∼2.5µm. Each of the first passivation layer and the second passivation layer is a passivation layer subjected to an annealing process, referring to FIG. 6.

With thicknesses of the above individual structural layers, it can be assured that manufacture of the first passivation layer is completed in a shorter time, that is, the production efficiency is guaranteed, while an adverse effect on the oxide semiconductor caused by hydrogen-containing groups is effectively avoided. If the thicknesses are set too thin, the effect of avoiding the oxide semiconductor from being affected by the hydrogen-containing group cannot be realized; and if the thicknesses are set too thick, a longer tact time is needed, causing reduction of the production efficiency.

In the example 3, as for the first passivation layer 407, besides the inorganic insulating material set forth above, a thin film formed of another inorganic insulating material whose material characteristics are the same as or similar to each of the above substances may be used as well.

In the example 3, as for the second passivation layer 408, besides a second inorganic insulating material set forth above, a thin film formed of another inorganic insulating material whose material characteristics are the same as or similar to each of the above substances may be used as well. Or, as for the second passivation layer, besides a first organic insulating material such as a resin insulating film, an acrylic insulating film or the like, a thin film formed of the like organic insulating material whose material characteristics are the same as or similar to each of the above substances may be used as well.

It should be noted that, an oxide is preferably selected as the material for the first passivation layer in the example 3, and an effective contact of this oxide with the oxide semiconductor layer at the position of the channel can be well established; a nitride is preferably selected for the second passivation layer, and this nitride can effectively prevent an interference on the oxide semiconductor layer which is exerted by hydrogen element or complex of hydrogen from outside.

Upon selection of a practical material, preferably different materials are selected for the first passivation layer and the second passivation layer respectively. When the first passivation layer and the second passivation layer adopt a same material, a structural design can be made on the material so that the passivation layer disposed close to the oxide semiconductor side is subjected to an oxygen-rich treatment to thereby increase oxygen content proportion in this substance, and the passivation layer disposed far away from the oxide semiconductor layer has a property of blocking permeation of external hydrogen atoms and water vapor to the thin film, thereby attaining required technical effects.

In the example 3, the first passivation layer 407 may adopt a first inorganic insulating material such as a silicon oxide thin film, an aluminum oxide thin film, a yttrium oxide thin film, a silicon oxynitride thin film or the like. These materials contain less content of the groups such as H+, OH- and so on per se and moreover have a certain ability of penetration resistant with respect to the groups such as H+, OH- and so on, so that diffusion of the groups such as H+, OH- and so on toward the oxide semiconductor layer can be suppressed well. Thus, an object of enhancing stability of the device is achieved and malfunction of the device is avoided. In order to enhance characteristics of the device to a great extent, it is possible that the second passivation layer which is made from a second inorganic insulating material such as silicon oxide, yttrium oxide, silicon oxynitride or the like or a first organic insulating material such as a resin insulating film, an acrylic insulating film or the like is immediately close to the pixel electrode layer. As such, an adhesion to the pixel electrode layer can be increased well, and an effect of enhancing stability of the device is attained.

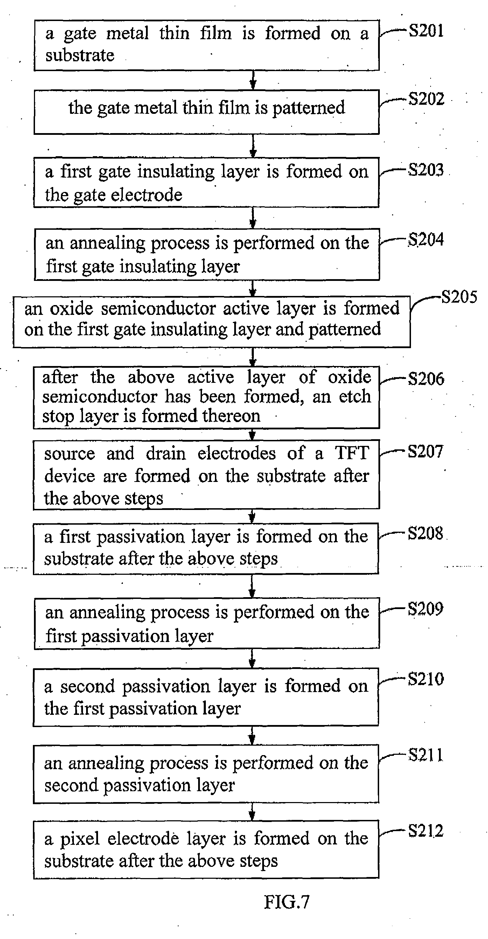

A method for manufacturing the array substrate will be described below in connection with an example in which a two-layered passivation layer and a single-layered gate insulating layer are adopted. As shown in FIG 7, the example of the method comprises the following steps.

Step S201, a gate metal thin film is formed on a substrate.

For example, a gate metal thin film is formed on a glass substrate 401. The gate metal thin film is usually produced by means of magnetron sputtering, copper and an alloy thereof may be selected as the material for gate metal thin film, of which the thickness is usually 200nm-350nm, and the sheet resistance is kept at a relatively low level.

Step S202, the gate metal thin film is patterned.

By means of wet etching, the gate metal thin film is patterned so as to form a gate line and a gate electrode 402. Further, if necessary, a common electrode line may be produced simultaneously.

Step S203, a first gate insulating layer is formed on the gate electrode.

For example, a silicon nitride thin film or a silicon oxynitride thin film is used to form the first gate insulating layer on the gate layer. A thickness of the first gate insulating layer may be 50 nm∼600nm.

Step S204, an annealing process is performed on the first gate insulating layer.

An annealing process is performed after the first gate insulating layer is formed so as to decrease the content of the groups such as H+, OH- and so on in the first gate insulating layer which might be broken and diffused. Thus, an effect of enhancing stability of the device is achieved.

Step S205, an oxide semiconductor active layer is formed on the first gate insulating layer and patterned.

Generally, indium gallium zinc oxide (IGZO), indium tin zinc oxide (ITZO), indium zinc oxide (IZO) and so on, as well as compositions of the above substances in different ratios, may be used for the oxide semiconductor. The main manufacturing methods comprise a magnetron sputtering deposition method, a solution method, etc. There are two etching processes that are commonly used for the active-layer oxide semiconductor, i.e., one process is wet etching, and the other is dry etching. The widely used process at present is wet etching, and etch accuracy can be well controlled. The oxide semiconductor is patterned by means of etching. Each of the following embodiments is the same as the above, and therefore details thereof will no longer be repeated.

Step S206, after the above active layer of oxide semiconductor has been formed, an etch stop layer is formed thereon.

Step S207, source and drain electrodes of a TFT device are formed on the substrate after the above steps.

Step S208, a first passivation layer is formed on the substrate after the above steps.

The first passivation layer 407 is a first inorganic insulating layer, which may comprise a silicon oxide thin film, an aluminum oxide thin film, an yttrium oxide thin film, a zirconium oxide thin film, a tantalum oxide thin film, a barium titanate thin film, a neodymium oxide thin film or a silicon oxynitride thin film. A thickness of the first passivation layer may be 50 nm∼600nm.

Step S209, an annealing process is performed on the first passivation layer.

The method of the annealing process may be: a heating chamber with nitrogen gas or air is incorporated into a PECVD apparatus, and a dehydrogenizing process is performed on the first passivation layer; the temperature in the annealing chamber may be 200°C∼350°C, and the annealing time period may be 15 min∼90min.

Step S210, a second passivation layer is formed on the first passivation layer.

The second passivation layer 408 is a second inorganic insulating layer or a first organic insulating layer, and the second inorganic insulating layer may comprise a silicon nitride thin film, an yttrium oxide thin film, a silicon oxynitride thin film, a zirconium oxide thin film, a tantalum oxide thin film, a barium titanate thin film or a neodymium oxide thin film. A thickness of the second passivation layer may be 50 nm∼500nm. The first organic insulating layer may comprise a resin insulating film or an acrylic insulating film. A thickness of the second passivation layer made from an organic insulating thin film layer may be 0.5µm∼2.5µm.

Step S211, an annealing process is performed on the second passivation layer.

The method of the annealing process may be: a heating chamber with nitrogen gas or air is incorporated into a PECVD apparatus, and a dehydrogenizing process is performed on the second passivation layer; the temperature in the annealing chamber may be 200°C∼350°C, and the annealing time period may be 15 min∼90min.

Step S212, a pixel electrode layer is formed on the substrate after the above steps.

In the example 3, except for the layered structure used for the gate insulating layer and the passivation layer, steps of manufacturing process for other film structures can be implemented by conventional technical means; however, they are not the design points of this example, and details thereof are omitted here. As for the gate insulating layer in this embodiment, in addition to that a single-layered structure can be adopted, a double-layered or three-layered structure as described in example 1 may also be used.

### Example 4

The difference between the example 4 for better understanding of the invention and the embodiment 3 lies in that: an array substrate provided in the example 4 is such an array substrate in which a gate layer for a thin film transistor is located on the top (i.e., an array substrate of a top-gate type). The passivation layer comprises a first passivation layer close to a gate electrode and a second passivation layer close to a pixel electrode layer. The structure, material and manufacturing method of the passivation layer are the same as the structure, material and manufacturing method of the passivation layer in the example 3, and a process method for forming each structural layer is the same case as the example 3, details thereof being omitted here.

### Example 5

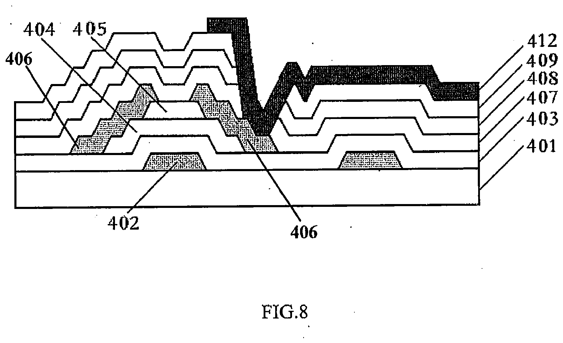

As shown in FIG 8, an array substrate provided in the example 5 for better understanding of the invention has such an array-substrate structure in which a gate layer for a thin film transistor is at the bottom (i.e., a bottom-gate type). The array substrate provided in the example 5 comprises: a gate electrode 402 located on a substrate 401, a gate insulating layer 403 and an active layer 404 which are located over the gate electrode 402 respectively, a source-drain electrode layer 406, a pixel electrode layer 412 and a passivation layer. The gate insulating layer 403 is located between the gate electrode 402 and the active layer 404; and the passivation layer is located between the source-drain electrode layer and the pixel electrode layer.

The active layer 404 is of an oxide semiconductor, the gate electrode is of Cu or Cu alloy, and the passivation layer has a three-layered structure comprising a first passivation layer 407 close to the source-drain electrode layer 406, a second passivation layer 408, and a third passivation layer 409 close to the pixel electrode layer 412. The second passivation layer 408 is located between the first passivation layer 407 and the third passivation layer 409.

The first passivation layer 407 is a first inorganic insulating layer, and the first inorganic insulating layer comprises a silicon oxide thin film, an aluminum oxide thin film, a titanium oxide thin film, a silicon oxynitride thin film, a zirconium oxide thin film, a tantalum oxide thin film, a barium titanate thin film, a neodymium oxide thin film or the like inorganic insulating material. A thickness of the first passivation layer may be 50 nm∼600nm.

The second passivation layer 408 is a second inorganic insulating layer or a first organic insulating layer; the second inorganic insulating layer may comprise a silicon oxide thin film, an aluminum oxynitride thin film, a zirconium oxynitride thin film, a tantalum oxynitride thin film, a neodymium oxynitride thin film or the like inorganic insulating material; and the first organic insulating layer may comprise a resin insulating thin film or an acrylic insulating thin film. The third passivation layer 409 is a third inorganic insulating layer or a second organic insulating layer; the third inorganic insulating layer may comprise a silicon nitride thin film, an aluminum nitride thin film, a zirconium nitride thin film, a tantalum nitride thin film or the like inorganic insulating material; and the second organic insulating layer may comprise a resin insulating thin film or an acrylic insulating thin film.

When the second passivation layer 408 is an inorganic insulating layer, a thickness of the second passivation layer may be 50 nm∼650nm; and when the second passivation layer is an organic insulating layer, a thickness of the second passivation layer may be 0.5µm∼2.5µm. When the third passivation layer 409 is an inorganic insulating layer, a thickness of the third passivation layer 409 may be 50 nm∼500nm; and when the third passivation layer 409 is an organic insulating layer, a thickness of the third passivation layer 408 may be 0.5µm∼2.5µm.

The inorganic insulating material of oxide which is adopted by the first passivation layer 407 close to the source-drain electrode layer 406 facilitates attachment to the oxide semiconductor active layer, thereby enhancing stability of the device. With the oxynitride or the like inorganic insulating material which is adopted by the second passivation layer 408, diffusion of the groups such as H+, OH- and so on toward the oxide semiconductor layer can be suppressed well thereby achieve an object of enhancing stability of the device and malfunction of the device is avoided, because the material contains less the groups such as H+, OH- and so on per se and further has a certain absorption ability with respect to the groups such as H+, OH- and so on. The material adopted by the third passivation layer 409 can prevent the device from being adversely affected by an outside hydrogen environment and further realize the effect of enhancing stability of the device.

With the thicknesses of the above individual structural layers, it can be assured that manufacture of the first passivation layer is completed in a shorter time, that is, the production efficiency is guaranteed, while an adverse effect on the oxide semiconductor caused by hydrogen-containing groups is effectively avoided. If the set thicknesses are too thin, an effect of avoiding the oxide semiconductor from being affected by the hydrogen-containing group cannot be realized; and if the set thicknesses are too thick, a longer tact time is needed, causing reduction of the production efficiency.

In the example 5, as for the first passivation layer, besides the material set forth above, a thin film formed of another inorganic insulating material whose material characteristics are the same as or similar to each of the above substances may be used as well.

In the example 5, as for the second passivation layer, besides the material set forth above, a thin film formed from other inorganic or organic insulating material whose material characteristics are the same as or similar to each of the above substances may be used as well.

In the example 5, as for the third passivation layer, besides the material set forth above, a thin film formed from other inorganic or organic insulating material whose material characteristics are the same as or similar to each of the above substances may be used as well.

The structure of the gate insulating layer in the example 5 is the same as the structure of the gate insulating layer in the example 1, and details thereof are omitted here.

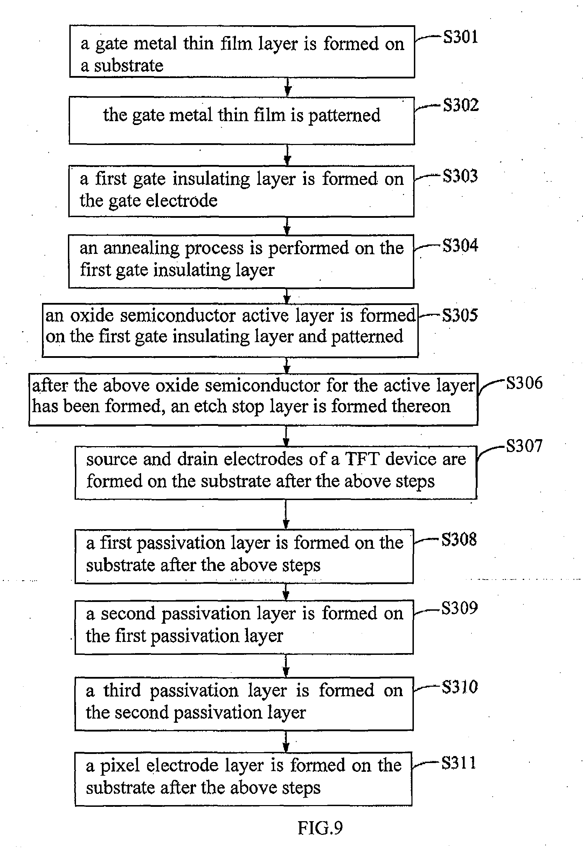

A method for manufacturing the array substrate will be described below in connection with an example in which a three-layered passivation layer and a single-layered gate insulating layer are adopted. As shown in FIG 9, the example of the method comprises the following steps.

Step S301, a gate metal thin film is formed on a substrate.

For example, a gate metal thin film is formed on a glass substrate 401. A gate metal thin film is usually produced by means of magnetron sputtering, and copper or an alloy thereof may be selected as the material for it, of which the thickness is usually 200nm-350nm, and the sheet resistance is kept at a relatively low level.

Step S302, the gate metal thin film is patterned.

For example, by means of wet etching, the gate metal thin film is patterned so as to form a gate line and a gate electrode 402. Further, if necessary, a common electrode line may be produced simultaneously.

Step S303, a first gate insulating layer is formed on the gate electrode.

For example, a silicon nitride thin film or a silicon oxynitride thin film is used to form the first gate insulating layer on the gate layer. A thickness of the first gate insulating layer may be 50 nm∼600nm.

Step S304, an annealing process is performed on the first gate insulating layer.

An annealing process is performed after the first gate insulating layer is formed, so as to decrease the content of the groups such as H+, OH- and so on in the first gate insulating layer which might be broken and diffused. Thus, an effect of enhancing stability of the device is achieved.

Step S305, an oxide semiconductor active layer is formed on the first gate insulating layer and patterned.

Generally, indium gallium zinc oxide (IGZO), indium tin zinc oxide (ITZO), indium zinc oxide (IZO) and so on, as well as compositions of the above substances in different ratios, may be used for the oxide semiconductor.

Step S306, after the above oxide semiconductor for the active layer has been formed, an etch stop layer is formed thereon.

Step S307, source and drain electrodes of a TFT device are formed on the substrate after the above steps.

Step S308, a first passivation layer is formed on the substrate after the above steps.

Step S309, a second passivation layer is formed on the first passivation layer.

Step S310, a third passivation layer is formed on the second passivation layer.

In the above steps, the first passivation layer 407 is a first inorganic insulating layer, which may comprise a silicon oxide thin film, an aluminum oxide thin film, a titanium oxide thin film, a silicon oxynitride thin film, a zirconium oxide thin film, a tantalum oxide thin film, a barium titanate thin film, a neodymium oxide thin film or the like inorganic insulating material. A thickness of the first passivation layer may be 50 nm∼600nm. The second passivation layer 408 may be a second inorganic insulating layer or a first organic insulating layer, the second inorganic insulating layer may comprise a silicon oxynitride thin film, an aluminum oxynitride thin film, a zirconium oxynitride thin film, a tantalum oxynitride thin film, a neodymium oxynitride thin film or the like inorganic insulating material, and the first organic insulating layer may comprise a resin insulating thin film or an acrylic insulating thin film. The third passivation layer 409 may be a third inorganic insulating layer or a second organic insulating layer. When the second passivation layer 408 is an inorganic insulating layer, a thickness of the second passivation layer may be 50 nm∼650mn; and when the second passivation layer 408 is an organic insulating layer, a thickness of the second passivation layer may be 0.5µm∼2.5µm.

The third passivation layer 409 is a third inorganic insulating layer or a second organic insulating layer, the third inorganic insulating layer may comprise a silicon nitride thin film, an aluminum nitride thin film, a zirconium nitride thin film, a tantalum nitride thin film or the like inorganic insulating material, and the second organic insulating layer may comprise a resin insulating thin film or an acrylic insulating thin film.

When the third passivation layer 409 is an inorganic insulating layer, a thickness of the third passivation layer 409 may be 50 nm∼500nm; and when the third passivation layer 409 is an organic insulating layer, a thickness of the third passivation layer 408 may be 0.5µm∼2.5µm.

Step S311, a pixel electrode layer is formed on the substrate after the above steps.

In the example except for the layered structure used for the gate insulating layer and the passivation layer, steps of manufacturing process for other film structures can be implemented by conventional technical means; they are not design points of this example, and details thereof are omitted here. As for the gate insulating layer in the example 5, in addition to that the single-layered structure is adopted, a double-layered or three-layered structure as described in example 1 may also be used.

### Example 6

The difference between the example 6 for better understanding of the invention and the example 5 lies in that: an array substrate provided in the example 6 is such an array substrate in which a gate layer for a thin film transistor is located on the top (i.e., an array substrate of a top-gate type). The passivation layer comprises a first passivation layer close to the gate layer, a second passivation layer, and a third passivation layer close to a pixel electrode layer. The second passivation layer is located between the first passivation layer and the third passivation layer. The structure, material and manufacturing method of the passivation layer are the same as the structure, material and manufacturing method of the passivation layer in the example 5, and a specific processing method for forming each structural layer may be the same case as the example
5, details thereof being omitted here.

### Example 7

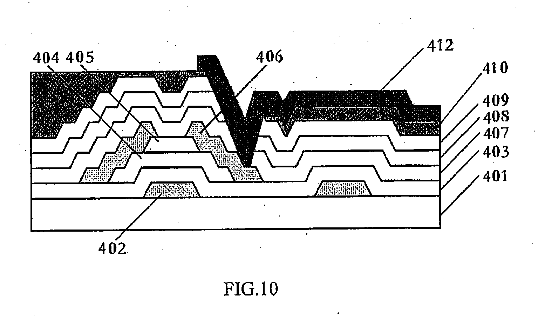

As shown in FIG. 10, an array substrate provided in the example 7 for better understanding of the invention has such an array-substrate structure in which a gate layer for a thin film transistor is at the bottom (i.e., a bottom-gate type). The array substrate provided in the example 7 comprises: a gate electrode 402 located on a substrate 401, a gate insulating layer 403 and an active layer 404 which are located over the gate electrode 402 respectively, a source-drain electrode layer 406, a pixel electrode layer 412 and a passivation layer. The gate insulating layer 403 is located between the gate electrode 402 and the active layer 404; and the passivation layer is located between the source-drain electrode layer and the pixel electrode layer.

The active layer 404 is of an oxide semiconductor, the gate electrode is of Cu or a Cu alloy, and the passivation layer has a four-layered structure comprising a first passivation layer 407 close to the source-drain electrode layer 406, a second passivation layer 408, a third passivation layer 409, and a fourth passivation layer 410 close to the pixel electrode layer 412. The second passivation layer 408 and the third passivation layer 409 are located between the first passivation layer 407 and the fourth passivation layer 410.

The first passivation layer 407 is a first inorganic insulating layer, which may comprise a silicon oxide thin film, an aluminum oxide thin film, a titanium oxide thin film, a silicon oxynitride thin film, a zirconium oxide thin film, a tantalum oxide thin film, a barium titanate thin film, a neodymium oxide thin film, an aluminum oxynitride thin film, a zirconium oxynitride thin film, a tantalum oxynitride thin film, or a neodymium oxynitride thin film. The second passivation layer 408 is a second inorganic insulating layer, which may comprise an aluminum oxynitride thin film, a zirconium oxynitride thin film, a tantalum oxynitride thin film or a neodymium oxynitride thin film. The third passivation layer 409 is a third inorganic insulating layer, which may comprise a silicon nitride thin film, an aluminum nitride thin film, a zirconium nitride thin film or a tantalum nitride thin film. The fourth passivation layer 410 is a first organic insulating layer, which may comprise a resin insulating thin film or an acrylic insulating thin film.

A thickness of the first passivation layer 407 may be 50 nm∼600nm; a thickness of the second passivation layer 408 may be 50 nm∼650nm; a thickness of the third passivation layer 409 may be 50 nm∼500nm; and a thickness of the fourth passivation layer may be 0.5µm∼2.5µm.

With thicknesses of the above individual structural layers, it is can assured that the manufacture of the first passivation layer is completed in a shorter time, that is, the production efficiency is guaranteed, while an effect on the oxide semiconductor caused by hydrogen-containing groups is effectively avoided. If the set thicknesses are too thin, an effect of avoiding the oxide semiconductor from being affected by the hydrogen-containing group cannot be realized; and if the set thicknesses are too thick, a longer tact time is needed, causing reduction of the production efficiency.

In the example 7, as for the first passivation layer, besides the material set forth above, a thin film formed of another inorganic insulating material whose material characteristics are the same as or similar to each of the above substances may be used as well.

In the example 7, as for the second passivation layer, besides the material set forth above, a thin film formed of another inorganic insulating material whose material characteristics are the same as or similar to each of the above substances may be used as well.

In the example 7, as for the third passivation layer, besides the material set forth above, a thin film formed of another inorganic insulating material whose material characteristics are the same as or similar to each of the above substances may be used as well.

In the example 7, as for the fourth passivation layer, besides the material set forth above, a thin film formed of the like organic insulating material whose material characteristics are the same as or similar to each of the above substances may be used as well.

In the example 7, with the silicon oxide thin film, the aluminum oxide thin film, the yttrium oxide thin film, the silicon oxynitride thin film or the like inorganic insulating material, which is employed by the first passivation layer, in cooperation with the silicon oxide thin film or the like inorganic insulating material employed by the second passivation layer, and the silicon nitride thin film or the like inorganic insulating material employed by the third passivation layer, diffusion of the groups such as H+, OH- and so on toward the oxide semiconductor layer can be suppressed well, an effect of enhancing stability of the device is achieved, and malfunction of the device is avoided, because these materials comprise less content of the groups such as H+, OH- and so on per se, and moreover have a certain ability of penetration resistant with respect to the groups such as H+, OH- and so on. In order to enhance characteristics of the device to a great extent, the fourth passivation layer is immediately close to the pixel electrode layer, by which adhesion to the pixel electrode layer can be increased as well. Thus, an effect of enhancing stability of the device is attained.

The structure of the gate insulating layer in the example 7 is the same as the structure of the gate insulating layer in the embodiment 1, and details thereof are omitted here.

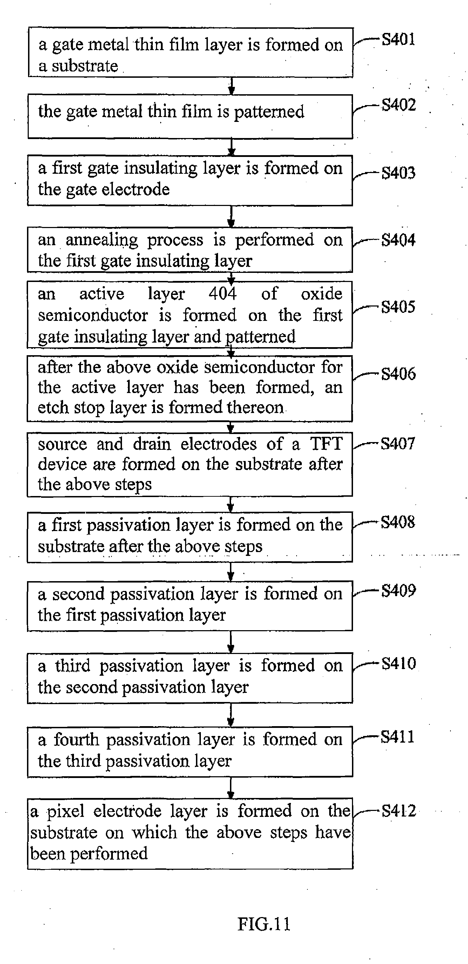

A method for manufacturing the array substrate will be described below in connection with an example in which a four-layered passivation layer and a single-layered gate insulating layer are adopted. As shown in FIG 11, the example of the method comprises the following steps.

Step S401, a gate metal thin film is formed on a substrate.

For example, a gate metal thin film is formed on a glass substrate 401. A gate metal thin film is usually produced by means of magnetron sputtering, copper or an alloy thereof may be selected as the material for the gate metal thin film, of which the thickness is usually 200nm-350nm, and the sheet resistance is kept at a relatively low level.

Step S402, the gate metal thin film is patterned.

For example, by means of wet etching, the gate metal thin film is patterned so as to form a gate line and a gate electrode 402. Further, if necessary, a common electrode line may be produced simultaneously.

Step S403, a first gate insulating layer is formed on the gate electrode.

For example, a silicon nitride thin film or a silicon oxynitride thin film is used to form the first gate insulating layer on the gate layer. A thickness of the first gate insulating layer may be 50 nm∼600nm.

Step S404, an annealing process is performed on the first gate insulating layer.

An annealing process is performed after the first gate insulating layer is formed, so as to decrease the content of the groups such as H+, OH- and so on in the first gate insulating layer which might be broken and diffused. Thus, an effect of enhancing stability of the device is attained.

Step S405, an active layer 404 of oxide semiconductor is formed on the first gate insulating layer and patterned.

Generally, indium gallium zinc oxide (IGZO), indium tin zinc oxide (ITZO), indium zinc oxide (IZO) and so on, as well as compositions of the above substances in different ratios, may be used for the oxide semiconductor.

Step S406, after the above oxide semiconductor for the active layer has been formed, an etch stop layer is formed thereon.

Step S407, source and drain electrodes of a TFT device are formed on the substrate after the above steps.

Step S408, a first passivation layer is formed on the substrate after the above steps.

For example, the first passivation layer 407 is a first inorganic insulating layer, and the first inorganic insulating layer comprises a silicon oxide thin film, an aluminum oxide thin film, a titanium oxide thin film, a silicon oxynitride thin film, a zirconium oxide thin film, a tantalum oxide thin film, a barium titanate thin film, a neodymium oxide thin film, an aluminum oxynitride thin film, a tantalum oxynitride thin film, or a neodymium oxynitride thin film. A thickness of the first passivation layer may be 50 nm∼600nm.

Step S409, a second passivation layer is formed on the first passivation layer.

For example, the second passivation layer 408 is a second inorganic insulating layer, and the second inorganic insulating layer comprises an aluminum oxynitride thin film, a zirconium oxynitride thin film, a tantalum oxynitride thin film, or a neodymium oxynitride thin film. A thickness of the second passivation layer may be 50 nm∼650nm.

Step S410, a third passivation layer is formed on the second passivation layer.

For example, the third passivation layer is a third inorganic insulating layer, and the third inorganic insulating layer comprises a silicon nitride thin film, an aluminum nitride thin film, a zirconium nitride thin film, or a tantalum nitride thin film. A thickness of the third passivation layer may be 50 nm∼500nm.

Step S411, a fourth passivation layer is formed on the third passivation layer.

For example, the fourth passivation layer is a first organic insulating layer, and the first organic insulating layer comprises a resin insulating thin film or an acrylic insulating thin film. A thickness of the fourth passivation layer may be 0.5µm∼2.5µm.

Step S412, a pixel electrode layer is formed on the substrate on which the above steps have been performed.

In the example 7, except for the layered structure used for the gate insulating layer and the passivation layer, steps of manufacturing process for other film structures can be implemented by conventional technical means; they are not design points of this example, and details thereof are omitted here. As for the gate insulating layer in the example 7, in addition to that the single-layered structure is adopted, a double-layered or three-layered structure as described in example 1 may also be used.

### Example 8

The difference between the example 8 for better understanding of the invention and the example 7 for better understanding of the invention lies in that: an array substrate provided in the example 8 is such an array substrate in which a gate layer for a thin film transistor is located on the top (i.e., an array substrate of a top-gate type). The passivation layer comprises a first passivation layer close to a gate electrode, a second passivation layer, a third passivation layer, and a fourth passivation layer close to a pixel electrode layer. The second passivation layer and the third passivation layer are located between the first passivation layer and the fourth passivation layer. The structure, material and manufacturing method of the passivation layer are the same as the structure, material and manufacturing method of the passivation layer in the example 7, and a specific processing method for forming each structural layer may be the same case as the example 7, details thereof being omitted here.

### Embodiment

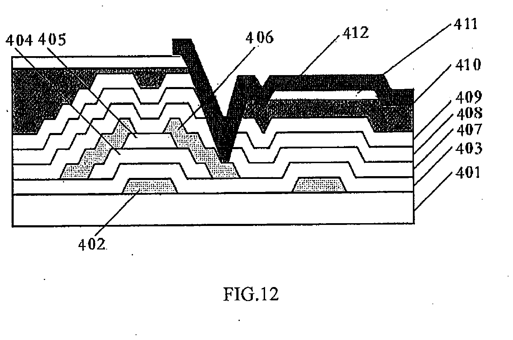

As shown in FIG. 12, an array substrate provided in the present embodiment has such an array-substrate structure in which a gate layer for a thin film transistor is at the bottom (i.e., a bottom-gate type). The array substrate provided in the present embodiment comprises: a gate electrode 402 located on a substrate 401, a gate insulating layer 403 and an active layer 404 which are located over the gate electrode respectively, a source-drain electrode layer 406, a pixel electrode layer 412 and a passivation layer. The gate insulating layer is located between the gate electrode and the active layer; and the passivation layer is located between the source-drain electrode layer and the pixel electrode layer.

The active layer 404 is of an oxide semiconductor, the gate electrode is of Cu or a Cu alloy, and the passivation layer has a five-layered structure comprising a first passivation layer 407, a second passivation layer 408, a third passivation layer 409, a fourth passivation layer 410, and a fifth passivation layer 411.

The first passivation layer 407 is close to the source-drain electrode layer 406, and the fifth passivation layer 411 is close to the pixel electrode layer 412; and the second passivation layer 408, the third passivation layer 409 and the fourth passivation layer 410 are located between the first passivation layer 407 and the fifth passivation layer 411.

The first passivation layer 407 is a first inorganic insulating layer, which may comprise a silicon oxide thin film, a titanium oxide thin film, a silicon oxynitride thin film, a zirconium oxide thin film, a tantalum oxide thin film, a barium titanate thin film, or a neodymium oxide thin film. The second passivation layer 408 is a second inorganic insulating layer, which may comprise a zirconium oxynitride thin film, a tantalum oxynitride thin film or a neodymium oxynitride thin film. The third passivation layer 409 is a third inorganic insulating layer, which may comprise a silicon nitride thin film, a zirconium nitride thin film or a tantalum nitride thin film. The fourth passivation layer 410 is a first organic insulating layer, which may comprise a resin insulating thin film or an acrylic insulating thin film. The fifth passivation layer 411 is a fourth inorganic insulating layer, which may comprise a zirconium oxide thin film, a tantalum oxide thin film, a barium titanate thin film, a neodymium oxide thin film, a zirconium oxynitride thin film, a neodymium oxynitride thin film, a zirconium nitride thin film or a tantalum nitride thin film. The fourth passivation layer employs an organic insulating material such as a resin insulating thin film, an acrylic insulating thin film or the like, so that aperture ratio of the array substrate can be effectively increased and coupling capacitance is decreased; and moreover, a planarization effect for reducing step difference can be realized. The fifth passivation layer employs an inorganic insulating material such as a silicon oxynitride thin film, a silicon oxide thin film, a silicon nitride thin film or the like, so that adhesion between the passivation layer and the pixel electrode layer can be strengthened and the problem that the organic insulating material fails during operation can be prevented effectively.

A thickness of the first passivation layer may be 50 nm∼600nm; a thickness of the second passivation layer may be 50 nm∼650nm; a thickness of the third passivation layer may be 50 nm∼500nm; a thickness of the fourth passivation layer may be 0.5µm∼2.5µm; and a thickness of the fifth passivation layer can be 20 nm∼450nm.

With thicknesses of the above individual structural layers, it can be assured that manufacture of the first passivation layer is completed in a shorter time, that is, the production efficiency is guaranteed, while an effect on the oxide semiconductor caused by hydrogen-containing groups is effectively avoided. If the set thicknesses are too thin, an effect of avoiding the oxide semiconductor from being affected by the hydrogen-containing group cannot be realized; and if the set thicknesses are too thick, a longer tact time is needed, causing reduction of the production efficiency.

The structure of the gate insulating layer in the embodiment is the same as structure of the gate insulating layer in the example 1, and details thereof are omitted here.

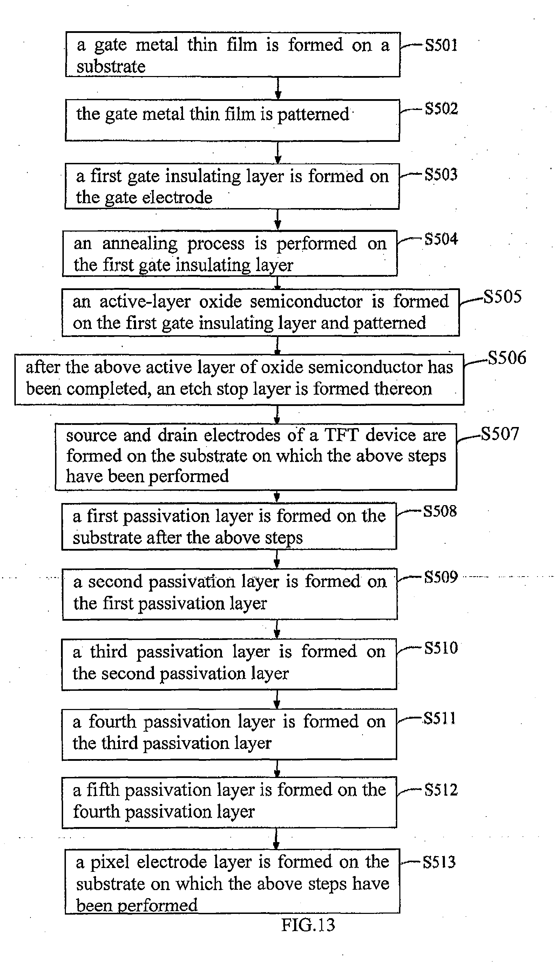

A method for manufacturing the array substrate will be described below in connection with an example in which a five-layered passivation layer and a single-layered gate insulating layer are adopted. As shown in FIG 13, the example of the method comprises the following steps.

Step S501, a gate metal thin film is formed on a substrate.

For example, a gate metal thin film is formed on a glass substrate 401. A gate metal thin film is usually produced by means of magnetron sputtering, copper and an alloy thereof may be selected as the material for the electrode, of which the thickness is usually 200nm-350nm, and the sheet resistance is kept at a relatively low level.

Step S502, the gate metal thin film is patterned.

For example, by means of wet etching, the gate layer is patterned so as to form a gate line and a gate electrode 402. Further, if necessary, a common electrode line may be produced simultaneously.

Step S503, a first gate insulating layer is formed on the gate electrode.

For example, a silicon nitride thin film or a silicon oxynitride thin film is used to form the first gate insulating layer on the gate layer. A thickness of the first gate insulating layer may be 50 nm∼600nm.

Step S504, an annealing process is performed on the first gate insulating layer.

An annealing process is performed after the first gate insulating layer is formed, so as to decrease the content of the groups such as H+, OH- and so on in the first gate insulating layer which might be broken and diffused. Thus, an effect of enhancing stability of the device is attained.

Step S505, an active-layer oxide semiconductor is formed on the first gate insulating layer and patterned.

Generally, indium gallium zinc oxide (IGZO), indium tin zinc oxide (ITZO), indium zinc oxide (IZO) and so on, as well as compositions of the above substances in different ratios, may be adopted for the oxide semiconductor.

Step S506, after the above active layer of oxide semiconductor has been completed, an etch stop layer is formed thereon.

Step S507, source and drain electrodes of a TFT device are formed on the substrate on which the above steps have been performed.

Step S508, a first passivation layer is formed on the substrate after the above steps.

The first passivation layer is a first inorganic insulating layer, which may comprise a silicon oxide thin film, a titanium oxide thin film, a silicon oxynitride thin film, a zirconium oxide thin film, a tantalum oxide thin film, a barium titanate thin film, or a neodymium oxide thin film. A thickness of the first passivation layer may be 50 nm∼600nm.

Step S509, a second passivation layer is formed on the first passivation layer.

The second passivation layer is a second inorganic insulating layer, and the second inorganic insulating layer comprises a zirconium oxynitride thin film, a tantalum oxynitride thin film, or a neodymium oxynitride thin film. A thickness of the second passivation layer may be 50 nm∼650nm.

Step S510, a third passivation layer is formed on the second passivation layer.

The third passivation layer is a third inorganic insulating layer, and the third inorganic insulating layer comprises a silicon nitride thin film, a zirconium nitride thin film, or a tantalum nitride thin film. A thickness of the third passivation layer may be 50 nm∼500nm.

Step S511, a fourth passivation layer is formed on the third passivation layer.

The fourth passivation layer is a first organic insulating layer, which comprises a resin insulating thin film or an acrylic insulating thin film. A thickness of the fourth passivation layer may be 0.5µm∼2.5µm.

Step S512, a fifth passivation layer is formed on the fourth passivation layer.

The fifth passivation layer is a fourth inorganic insulating layer, and the fourth inorganic insulating layer comprises a zirconium oxide thin film, a tantalum oxide thin film, a barium titanate thin film, a neodymium oxide thin film, a zirconium oxynitride thin film, a tantalum oxynitride thin film, a neodymium oxynitride thin film, a zirconium nitride thin film or a tantalum nitride thin film. A thickness of the fifth passivation layer can be 20 nm∼450nm.

Step S513, a pixel electrode layer is formed on the substrate on which the above steps have been performed.

In the present embodiment, except for the layered structure used for the gate insulating layer and the passivation layer, steps of manufacturing process for every other film structure can be implemented by conventional technical means; they are not design points of this embodiment, and details thereof are omitted here. As for the gate insulating layer in the embodiment, in addition to that the single-layered structure is adopted, a double-layered or three-layered structure as described in embodiment 1 may also be used.

### Example 9

The difference between the example 9 for better understanding of the invention and the embodiment lies in that: an array substrate provided in the present embodiment is such an array substrate in which a gate layer for a thin film transistor is located on the top (i.e., an array substrate of a top-gate type). The passivation layer comprises a first passivation layer close to the gate layer, a second passivation layer, a third passivation layer, a fourth passivation layer, and a fifth passivation layer close to a pixel electrode layer. The second passivation layer, the third passivation layer and the fourth passivation layer are located between the first passivation layer and the fifth passivation layer. The structure, material and manufacturing method of the passivation layer are the same as the structure, material and manufacturing method of the passivation layer in the example 7, and a specific processing method for forming each structural layer is the same case as the embodiment , details thereof being omitted here.

### Method for manufacturing the embodiment

A method for manufacturing an array substrate will be described below in connection with an example which is based on the five-layered passivation layer in the embodiment in combination with a three-layered gate insulating layer. The example of the method comprises the following steps.

Step S601, a gate metal thin film is formed on a substrate.

For example, a gate metal thin film is formed on a glass substrate. During manufacture of TFTs, gate electrodes are generally produced by means of magnetron sputtering, and the materials for the electrodes can be selected according to different device structures and process requirements. Gate metals which are usually employed comprise Mo, Mo-Al-Mo alloy, a stacked structure of Mo/Al-Nd/Mo, purified Al and Al alloy, Cu and Cu alloy, Mo/Nd/Cu, Ti/Cu or the like metals, the thicknesses are usually 200nm-350nm, and the sheet resistances are kept at a relatively low level.

Step S602, the gate metal thin film is patterned.

For example, by means of wet etching, the gate layer is patterned so as to form a gate electrode and a common electrode line.

Step S603, a silicon nitride thin film or a silicon oxynitride thin film is used to form a first gate insulating layer on the gate electrode. A thickness of the first gate insulating layer may be 50 nm∼300nm.

Step S604, a silicon oxynitride thin film is used to form a second gate insulating layer on the first gate insulating layer.

Step S605, silicon oxide, aluminum oxide or titanium oxide is used to form a third gate insulating layer on the second gate insulating layer.

Step S606, an oxide semiconductor active layer is formed on the third gate insulating layer and patterned.

For the formation of the oxide semiconductor active layer, the oxide semiconductor may be indium gallium zinc oxide (IGZO), indium tin zinc oxide (ITZO), indium zinc oxide (IZO) or the like, as well as compositions consisted of the above substances in different ratios.

Step S607, an etch stop layer is formed and patterned.

The etch stop layer (ESL) is directly formed on the patterned oxide semiconductor layer, and it is usual that an inorganic insulating material, such as SiOx, SiNx, SiOxNy, Al₂O₃, TiOx, Y₂O₃ or the like, may be used, so that the damages to the oxide semiconductor thin film during patterning of a data line can be reduced. Moreover, stability of the device can be effectively improved, thereby avoiding the device from being affected by an external environment. A patterning is carried out on the ESL, and a dry etching method is usually adopted.

Step S608, the data line is formed.

Subsequent to the manufacturing processes of S606 and S607, the data line is formed. Firstly, a metal layer is deposited so as to form an electrode layer for data-line and power-supply-line. The metal layer is generally fabricated by means of magnetron sputtering, and the material for the metal layer can be selected according to different device structures and process requirements. Electrode metals which are usually adopted comprise Mo, Mo-Al-Mo alloy, a stacked structure of Mo/Al-Nd/Mo, Cu and metal titanium and alloys thereof, ITO electrode, Ti/Al/Ti, Mo/ITO, etc., the thicknesses are usually 100 nm-350 nm, and the sheet resistances are kept at a relatively low level. After formation of the metal electrode layer, a patterning process is performed thereon. Generally, it is patterned by means of wet etching.

Step S609, on the substrate after completion of the above steps, a first passivation layer is formed. The first passivation layer is a first inorganic insulating layer, which comprises a silicon oxide thin film, a titanium oxide thin film, a silicon oxynitride thin film, a zirconium oxide thin film, a tantalum oxide thin film, a barium titanate thin film or a neodymium oxide thin film. A thickness of the first passivation layer may be 50 nm∼600nm.

Step S610, a second passivation layer is formed on the first passivation layer. The second passivation layer is a second inorganic insulating layer, and the second inorganic insulating layer comprises a zirconium oxynitride thin film, a tantalum oxynitride thin film, or a neodymium oxynitride thin film. A thickness of the second passivation layer may be 50 nm∼650nm.

Step S611, a third passivation layer is formed on the second passivation layer. The third passivation layer is a third inorganic insulating layer, and the third inorganic insulating layer comprises a silicon nitride thin film, a zirconium nitride thin film, or a tantalum nitride thin film. A thickness of the third passivation layer may be 50 nm∼500nm.

Step S612, a fourth passivation layer is formed on the third passivation layer. The fourth passivation layer is a first organic insulating layer, which comprises a resin insulating thin film or an acrylic insulating thin film. A thickness of the fourth passivation layer may be 0.5µm∼2.5µm.

Step S613, a fifth passivation layer is formed on the fourth passivation layer. The fifth passivation layer is a fourth inorganic insulating layer, which comprises a zirconium oxide thin film, a tantalum oxide thin film, a barium titanate thin film, a neodymium oxide thin film, a zirconium oxynitride thin film, a tantalum oxynitride thin film, a neodymium oxynitride thin film, a zirconium nitride thin film or a tantalum nitride thin film. A thickness of the fifth passivation layer can be 20 nm∼450nm.

Step S614, a via-hole is formed by etching and a pixel electrode is formed by deposition and patterning.

An etching process of the via hole is carried out after formation of the passivation layer so as to achieve conductive lines and connection to a pixel electrode. After completion of the foregoing process, deposition and patterning of the pixel electrode are carried out. As shown in the figure, after formation of the via hole, a pixel electrode layer is formed and then patterned by means of wet etching. Indium tin oxide (ITO) is typically used as the material for the pixel electrode layer at present.

As for the above method of manufacturing the array substrate, except for manufacturing methods of the gate insulating layer and the passivation layer, other structural layers can be produced by a conventional processing method.

The foregoing examples and embodiment and corresponding accompanied drawings each have been illustrated with a TN mode as an example for explaining the array substrate structure provided by the invention. In the structure of a TN mode array substrate, the pixel electrode is usually located above a passivation layer. Two layers of transparent electrode are contained in the structure of an ADS mode array substrate, and are located on the upper and lower sides of a passivation layer, respectively (e.g., the transparent electrode located under the passivation layer may be produced on a substrate directly); and the layer of transparent electrode which is located above the passivation layer may be a pixel electrode or a common electrode.

In an Advanced Super Dimensional Switching (ADS or AD-SDS) technology, a multi-dimensional electric field is formed by an electric field produced at edges of slit electrodes within the same plane and an electric field produced between a layer of the slit electrodes and a layer of a plate-like electrode so as to allow liquid crystal molecules of all alignment within a liquid crystal cell, which are located directly above the electrodes and between the slit electrodes, to be rotated, thereby enhancing the work efficiency of liquid crystals and increasing the transmissive efficiency. The Advanced Super Dimensional Switching technology can improve the picture quality of TFT-LCD products, and can realize advantages of high resolution, high transmissivity, low power consumption, wide viewing angle, high aperture ratio, low chromatic aberration, push Mura-free, etc.

Regarding the various array substrates as well as manufacturing methods thereof according to embodiments of the invention, they may be array substrates for liquid crystal display, such as TN mode array substrates, ADS mode array substrates, IPS mode array substrates or VA mode array substrates, and may also be array substrates for OLED display.

Furthermore, according to an embodiment of the invention, there is further provided a display device, comprising the foregoing array substrate. The display device comprises but is not limited to a liquid crystal panel, an OLED panel, a liquid crystal display, a liquid crystal television, a liquid crystal display panel, a tablet computer or other electronic display apparatus.

According to the display device, the array substrate and method for manufacturing the same provided by embodiments of the invention, the gate insulating layer and the passivation layer in the array substrate are produced by using a layered structure in combination with an annealing process. A hydrogen-containing group in the passivation layer and in the outside environment can be decreased to a great extent by using the layered structure, so that the oxide semiconductor can be effectively avoided from being affected by the hydrogen-containing group. Thus, stability of the whole TFT device is enhanced to a great extent, and yield of final products is increased.

The descriptions made as above are merely exemplary embodiments of the present invention, and not used to limit the protection scope of the invention. The protection scope of the present invention is defined by attached claims.

## Claims

1. An array substrate, comprising a substrate (401) and a thin film transistor and a pixel electrode (412) which are formed on the substrate (401), the thin film transistor comprising a gate electrode (402), a gate insulating layer (403), an active layer (404), and source and drain electrodes (406), and being overlaid with a passivation layer;
wherein the active layer (404) of the thin film transistor is of an oxide semiconductor;
the passivation layer is a multilayered passivation layer comprising a first passivation layer (407), a second passivation layer (408), a third passivation layer (409), a fourth passivation layer (410), and a fifth passivation layer (411) which are disposed in sequence; wherein the first passivation layer (407) is close to the thin film transistor;
wherein the first passivation layer (407) is a first inorganic insulating layer, which comprises a silicon oxide thin film, a titanium oxide thin film, a silicon oxynitride thin film, a zirconium oxide thin film, a tantalum oxide thin film, a barium titanate thin film, or a neodymium oxide thin film;
wherein the second passivation layer (408) is a second inorganic insulating layer, which comprises , a zirconium oxynitride thin film, a tantalum oxynitride thin film, or a neodymium oxynitride thin film;
wherein the third passivation layer (409) is a third inorganic insulating layer, which comprises a silicon nitride thin film, a zirconium nitride thin film, or a tantalum nitride thin film;
wherein the fourth passivation layer (410) is a first organic insulating layer, which comprises a resin insulating thin film or an acrylic insulating thin film; and
wherein the fifth passivation layer (411) is a fourth inorganic insulating layer, which comprises a zirconium oxide thin film, a tantalum oxide thin film, a barium titanate thin film, a neodymium oxide thin film, a zirconium oxynitride thin film, a tantalum oxynitride thin film, a neodymium oxynitride thin film, a zirconium nitride thin film or a tantalum nitride thin film: and
wherein the fifth passivation layer (411) is in contact with the fourth passivation layer (410) and the pixel electrode (412).

2. The array substrate according to claim 1, wherein the thickness of the first passivation layer (407) is 50 nm∼600nm; the thickness of the second passivation layer (408) is 50 nm∼650nm; the thickness of the third passivation layer (409) is 50 nm∼500nm; the thickness of the fourth passivation layer (410) is 0.5µm∼2.5µm; and the thickness of the fifth passivation layer (411) is 20 nm∼450nm.

3. The array substrate according to any one of claims 1 or 2, wherein the gate insulating layer (403) is located between the active layer (404) and the gate electrode (402); and the gate insulating layer (403) comprises at least one layer of inorganic insulating thin film.

4. The array substrate according to claim 3, wherein the gate insulating layer (403) includes a first gate insulating layer close to the gate electrode and a second gate insulating layer close to the active layer;
the first gate insulating layer is an aluminum oxynitride thin film, a silicon oxynitride thin film, a zirconium oxynitride thin film, a tantalum oxynitride thin film, an yttrium oxynitride thin film, a neodymium oxynitride thin film, a silicon nitride thin film, an aluminum nitride thin film, a zirconium nitride thin film or a tantalum nitride thin film; and
the second gate insulating layer is a silicon oxide thin film, an yttrium oxide thin film, an aluminum oxide thin film, a titanium oxide thin film, a zirconium oxide thin film, a tantalum oxide thin film, a barium titanate thin film, a neodymium oxide thin film, an aluminum oxynitride thin film, a silicon oxynitride thin film, a zirconium oxynitride thin film, a tantalum oxynitride thin film, an yttrium oxynitride thin film or a neodymium oxynitride thin film.

5. The array substrate according to claim 4, wherein the first gate insulating layer is obtainable by subjecting an insulating layer to an annealing process; and the second gate insulating layer is obtainable by subjecting an insulating layer to an annealing process.

6. The array substrate according to claim 4 or 5, wherein the thickness of the first gate insulating layer is 50nm-600nm; and the thickness of the second gate insulating layer is 50nm-650nm.

7. The array substrate according to claim 6, wherein the gate insulating layer includes a first gate insulating layer close to the gate electrode, a second gate insulating layer, and a third gate insulating layer close to the active layer, and the second gate insulating layer is located between the first gate insulating layer and the third gate insulating layer;
wherein the first gate insulating layer is a silicon nitride thin film, an aluminum nitride thin film, a zirconium nitride thin film or a tantalum nitride thin film;
wherein the second gate insulating layer is an aluminum oxynitride thin film, a silicon oxynitride thin film, a zirconium oxynitride thin film, a tantalum oxynitride thin film, an yttrium oxynitride thin film, or a neodymium oxynitride thin film; and
wherein the third gate insulating layer is a silicon oxide thin film, an yttrium oxide thin film, an aluminum oxide thin film, a titanium oxide thin film, a zirconium oxide thin film, a tantalum oxide thin film, a barium titanate thin film, a neodymium oxide thin film, an aluminum oxynitride thin film, a silicon oxynitride thin film, a zirconium oxynitride thin film, a tantalum oxynitride thin film, an yttrium oxynitride thin film or a neodymium oxynitride thin film.

8. The array substrate according to claim 7, wherein the thickness of the first gate insulating layer is 50 nm∼600nm; the thickness of the second gate insulating layer is 50 nm∼650nm; and the thickness of the third gate insulating layer is 20 nm∼600nm.

9. The array substrate according to any one of claims 1-8, wherein the gate electrode (402) and/or the source and drain electrodes (406) are electrodes of copper or copper alloy.

10. A display device, comprising an array substrate according to any one of the claims 1 to 9.

## Patentansprüche

1. Array-Substrat aufweisend ein Substrat (401) und einen Dünnschichttransistor und eine Pixelelektrode (412), die auf dem Substrat (401) ausgebildet sind, wobei der Dünnschichttransistor eine Gate-Elektrode (402), eine Gate-Isolationsschicht (403), eine Aktivschicht (404) und Source- und Drain-Elektroden (406) aufweist und mit einer Passivierungsschicht überzogen ist;
wobei die Aktivschicht (404) des Dünnschichttransistors ein Oxidhalbleiter ist;
wobei die Passivierungsschicht eine mehrschichtige Passivierungsschicht ist, die eine erste Passivierungsschicht (407), eine zweite Passivierungsschicht (408), eine dritte Passivierungsschicht (409), eine vierte Passivierungsschicht (410) und eine fünfte Passivierungsschicht (411) aufweist, die nacheinander angeordnet sind; wobei die erste Passivierungsschicht (407) nahe an dem Dünnschichttransistor ist;
wobei die erste Passivierungsschicht (407) eine erste anorganische Isolationsschicht ist, die eine Siliziumoxid-Dünnschicht, eine Titanoxid-Dünnschicht, eine Siliziumoxinitrid-Dünnschicht, eine Zirkonoxid-Dünnschicht, eine Tantaloxid-Dünnschicht, eine Bariumtitanat-Dünnschicht oder eine Neodymoxid-Dünnschicht aufweist;
wobei die zweite Passivierungsschicht (408) eine zweite anorganische Isolationsschicht ist, die eine Zirkonoxidnitrid-Dünnschicht, eine Tantaloxidnitrid-Dünnschicht, oder eine Neodymoxidnitrid-Dünnschicht aufweist;
wobei die dritte Passivierungsschicht (409) eine dritte anorganische Isolationsschicht ist, die eine Siliziumnitrid-Dünnschicht, eine Zirkonnitrid-Dünnschicht oder eine Tantalnitrid-Dünnschicht aufweist;
wobei die vierte Passivierungsschicht (410) eine erste organische Isolationsschicht ist, die eine Harzisolator-Dünnschicht oder eine Akrylisolator-Dünnschicht aufweist, und
wobei die fünfte Passivierungsschicht (411) eine vierte anorganische Isolationsschicht ist, die eine Zirkonoxid-Dünnschicht, eine Tantaloxid-Dünnschicht, eine Bariumtitanat-Dünnschicht, eine Neodymoxid-Dünnschicht, eine Zirkonoxidnitrid-Dünnschicht, eine Tantaloxidnitrid-Dünnschicht, eine Neodymoxidnitrid-Dünnschicht, eine Zirkonnitrid-Dünnschicht oder eine Tantalnitrid-Dünnschicht aufweist; und
wobei die fünfte Passivierungsschicht (411) in Kontakt mit der vierten Passivierungsschicht (410) und der Pixelelektrode (412) steht.

2. Array-Substrat gemäß Anspruch 1, wobei die Dicke der ersten Passivierungsschicht (407) 50 nm ∼ 600 nm beträgt; die Dicke der zweiten Passivierungsschicht (408) 50 nm ∼ 650 nm beträgt, die Dicke der dritten Passivierungsschicht (409) 50 nm bis 500 nm beträgt; die Dicke der vierten Passivierungsschicht (410) 0,5 µm ∼ 2,5 µm beträgt; und die Dicke der fünften Passivierungsschicht (411) 20 nm ∼ 450 nm beträgt.

3. Array-Substrat gemäß einem der Ansprüche 1 oder 2, wobei sich die Gate-Isolierschicht (403) zwischen der Aktivschicht (404) und der Gate-Elektrode (402) befindet; und die Gate-Isolationsschicht (403) wenigstens eine Schicht einer anorganischen Isolator-Dünnschicht aufweist.

4. Array-Substrat gemäß Anspruch 3, wobei die Gate-Isolationsschicht (403) aufweist erste Gate-Isolationsschicht nahe der Gate-Elektrode und eine zweite Gate-Isolationsschicht nahe der Aktivschicht;
wobei die erste Gate-Isolationsschicht eine Aluminiumoxinitrid-Dünnschicht, eine Siliziumoxidnitrid-Dünnschicht, eine Zirkonoxinitrid-Dünnschicht, eine Tantaloxidnitrid-Dünnschicht, eine Yttriumoxidnitrid-Dünnschicht, eine Neodymoxinitrid-Dünnschicht, eine Siliziumnitrid-Dünnschicht, eine Aluminiumnitrid-Dünnschicht, eine Zirkonnitrid-Dünnschicht oder eine Tantalnitrid-Dünnschicht ist; und
wobei die zweite Gate-Isolationsschicht eine Siliziumoxid-Dünnschicht, eine Yttriumoxid-Dünnschicht, eine Aluminiumoxid-Dünnschicht, eine Titanoxid-Dünnschicht, eine Zirkonoxid-Dünnschicht, eine Tantaloxid-Dünnschicht, eine Bariumtitanat-Dünnschicht, eine Neodymoxid-Dünnschicht, eine Aluminiumoxinitrid-Dünnschicht, eine Siliziumoxinitrid-Dünnschicht, eine Zirkonoxinitrid-Dünnschicht, eine Tantaloxinitrid-Dünnschicht oder eine Neodymoxinitrid-Dünnschicht ist.

5. Array-Substrat gemäß Anspruch 4, wobei die erste Gate-Isolationsschicht erhalten werden kann, indem eine Isolationsschicht einem Ausglühprozess unterworfen wird; und die zweite Gate-Isolationsschicht erhalten werden kann, indem eine Isolationsschicht einem Ausglühprozess unterworfen wird.

6. Array-Substrat gemäß Anspruch 4 oder 5, wobei die Dicke der ersten Gate-Isolationsschicht 50 nm - 600 nm beträgt; und die Dicke der zweiten Gate-Isolationsschicht 50 nm bis 650 nm beträgt.

7. Array-Substrat gemäß Anspruch 6, wobei die Gate-Isolationsschicht aufweist eine Gate-Isolationsschicht nahe der Gate-Elektrode, eine zweite Gate-Isolationsschicht und eine dritte Gate-Isolationsschicht nahe der Aktivschicht, und die zweite Gate-Isolationsschicht sich zwischen der ersten Gate-Isolationsschicht und der dritten Gate-Isolationsschicht befindet;
wobei die erste Gate-Isolationsschicht eine Siliziumnitrid-Dünnschicht, eine Aluminiumnitrid-Dünnschicht, eine Zirkonnitrid-Dünnschicht oder eine Tantalnitrid-Dünnschicht ist;
wobei die zweite Gate-Isolationsschicht eine Aluminiumoxinitrid-Dünnschicht, eine Siliziumoxinitrid-Dünnschicht, eine Zirkonoxinitrid-Dünnschicht, eine Tantaloxinitrid-Dünnschicht, eine Yttriumoxinitrid-Dünnschicht oder eine Neodymoxinitrid-Dünnschicht ist; und
wobei die dritte Gate-Isolationsschicht eine Siliziumoxiddünnschicht, eine Yttriumoxid-Dünnschicht, eine Aluminiumoxid-Dünnschicht, eine Titanoxid-Dünnschicht, eine Zirkonoxid-Dünnschicht, eine Tantaloxid-Dünnschicht, eine Bariumtitanat-Dünnschicht, eine Neodymoxid-Dünnschicht, eine Aluminiumoxinitrid-Dünnschicht, eine Siliziumoxinitrid-Dünnschicht, eine Zirkonoxinitrid-Dünnschicht, eine Tantaloxinitrid-Dünnschicht, eine Yttriumoxinitrid-Dünnschicht oder eine Neodymoxinitrid-Dünnschicht ist.

8. Array-Substrat nach Anspruch 7, wobei die Dicke der ersten Gate-Isolationsschicht 50 nm ∼ 600 nm beträgt, die Dicke der zweiten Gate-Isolationsschicht 50 nm ∼ 650 nm beträgt; und die Dicke der dritten Gate-Isolationsschicht 20 nm ∼ 600 nm beträgt.

9. Array-Substrat gemäß einem der Ansprüche 1 bis 8, wobei die Gate-Elektrode (402) und/oder die Source- und Drain-Elektrode (406) Elektroden aus Kupfer oder einer Kupferlegierung sind.

10. Anzeigevorrichtung mit einem Array-Substrat gemäß einem der Ansprüche 1 bis 9.

## Revendications

1. Substrat matriciel, comprenant un substrat (401), un transistor à couches minces, et une électrode de pixel (412), lesquels sont formés sur le substrat (401), le transistor à couches minces comprenant une électrode de grille (402), une couche d'isolation de grille (403), une couche active (404), et des électrodes de source et de drain (406), et étant recouvert d'une couche de passivation ;
dans lequel la couche active (404) du transistor à couches minces est constituée d'un oxyde semi-conducteur ;
la couche de passivation est une couche de passivation multicouche comprenant une première couche de passivation (407), une deuxième couche de passivation (408), une troisième couche de passivation (409), une quatrième couche de passivation (410), et une cinquième couche de passivation (411), lesquelles sont disposées dans l'ordre ;
dans lequel la première couche de passivation (407) se trouve à proximité du transistor à couches minces ;
dans lequel la première couche de passivation (407) est une première couche d'isolation inorganique, laquelle comprend un film mince d'oxyde de silicium, un film mince d'oxyde de titane, un film mince d'oxynitrure de silicium, un film mince d'oxyde de zirconium, un film mince d'oxyde de tantale, un film mince de titanate de baryum, ou un film mince d'oxyde de néodyme ;
dans lequel la deuxième couche de passivation (408) est une deuxième couche d'isolation inorganique, laquelle comprend un film mince d'oxynitrure de zirconium, un film mince d'oxynitrure de tantale, ou un film mince d'oxynitrure de néodyme ;
dans lequel la troisième couche de passivation (409) est une troisième couche d'isolation inorganique, laquelle comprend un film mince de nitrure de silicium, un film mince de nitrure de zirconium, ou un film mince de nitrure de tantale ;
dans lequel la quatrième couche de passivation (410) est une première couche d'isolation inorganique, laquelle comprend un film mince isolant de résine ou un film mince isolant acrylique, et
dans lequel la cinquième couche de passivation (411) est une quatrième couche d'isolation inorganique, laquelle comprend un film mince d'oxyde de zirconium, un film mince d'oxyde de tantale, un film mince de titanate de baryum, un film mince d'oxyde de néodyme, un film mince d'oxynitrure de zirconium, un film mince d'oxynitrure de tantale, un film mince d'oxynitrure de néodyme, un film mince de nitrure de zirconium, ou un film mince nitrure de tantale, et
dans lequel la cinquième couche de passivation (411) est en contact avec la quatrième couche de passivation (410) et l'électrode de pixel (412).

2. Substrat matriciel selon la revendication 1, dans lequel l'épaisseur de la première couche de passivation (407) est de 50 nm∼600 nm ; l'épaisseur de la deuxième couche de passivation (408) est de 50 nm∼650 nm ; l'épaisseur de la troisième couche de passivation (409) est de 50 nm∼500 nm ; l'épaisseur de la quatrième couche de passivation (410) est de 0,5 µm∼2,5 µm, et l'épaisseur de la cinquième couche de passivation (411) est de 20 nm∼450 nm.

3. Substrat matriciel selon la revendication 1 ou 2, dans lequel la couche d'isolation de grille (403) se trouve entre la couche active (404) et l'électrode de grille (402), et la couche d'isolation de grille (403) comprend au moins une couche de film mince isolant inorganique.

4. Substrat matriciel selon la revendication 3, dans lequel la couche d'isolation de grille (403) inclut une première couche d'isolation de grille à proximité de l'électrode de grille et une seconde couche d'isolation de grille à proximité de la couche active ;
la première couche d'isolation de grille est un film mince d'oxynitrure d'aluminium, un film mince d'oxynitrure de silicium, un film mince d'oxynitrure de zirconium, un film mince d'oxynitrure de tantale, un film mince d'oxynitrure d'yttrium, un film mince d'oxynitrure de néodyme, un film mince de nitrure de silicium, un film mince de nitrure d'aluminium, un film mince de nitrure de zirconium, ou un film mince d'oxynitrure de tantale, et
la seconde couche d'isolation de grille est un film mince d'oxyde de silicium, un film mince d'oxyde d'yttrium, un film mince d'oxyde d'aluminium, un film mince d'oxyde de titane, un film mince d'oxyde de zirconium, un film mince d'oxyde de tantale, un film mince de titanate de baryum, un film mince d'oxyde de néodyme, un film mince d'oxynitrure d'aluminium, un film mince d'oxynitrure de silicium, un film mince d'oxynitrure de zirconium, un film mince d'oxynitrure de tantale, un film mince d'oxynitrure d'yttrium, ou un film mince d'oxynitrure de néodyme.

5. Substrat matriciel selon la revendication 4, dans lequel la première couche d'isolation de grille peut être obtenue en soumettant une couche d'isolation à un processus de recuit, et la seconde couche d'isolation de grille peut être obtenue en soumettant une couche d'isolation à un processus de recuit.

6. Substrat matriciel selon la revendication 4 ou 5, dans lequel l'épaisseur de la première couche d'isolation de grille est de 50 nm∼600 nm, et l'épaisseur de la deuxième couche d'isolation de grille est de 50 nm∼650 nm.

7. Substrat matriciel selon la revendication 6, dans lequel la couche d'isolation de grille inclut une première couche d'isolation de grille à proximité de l'électrode de grille, une deuxième couche d'isolation de grille, et une troisième couche d'isolation de grille à proximité de la couche active, et la deuxième couche d'isolation de grille se trouve entre la première couche d'isolation de grille et la troisième couche d'isolation de grille ;
dans lequel la première couche d'isolation de grille est un film mince de nitrure de silicium, un film mince de nitrure d'aluminium, un film mince de nitrure de zirconium, ou un film mince de nitrure de tantale ;
dans lequel la deuxième couche d'isolation de grille est un film mince d'oxynitrure d'aluminium, un film mince d'oxynitrure de silicium, un film mince d'oxynitrure de zirconium, un film mince d'oxynitrure de tantale, un film mince d'oxynitrure d'yttrium, ou un film mince d'oxynitrure de néodyme ;
dans lequel la troisième couche d'isolation de grille est un film mince d'oxyde de silicium, un film mince d'oxyde d'yttrium, un film mince d'oxyde d'aluminium, un film mince d'oxyde de titane, un film mince d'oxyde de zirconium, un film mince d'oxyde de tantale, un film mince de titanate de baryum, un film mince d'oxyde de néodyme, un film mince d'oxynitrure d'aluminium, un film mince d'oxynitrure de silicium, un film mince d'oxynitrure de zirconium, un film mince d'oxynitrure de tantale, un film mince d'oxynitrure d'yttrium, ou un film mince d'oxynitrure de néodyme.

8. Substrat matriciel selon la revendication 7, dans lequel l'épaisseur de la première couche d'isolation de grille est de 50 nm∼600 nm ; l'épaisseur de la deuxième couche d'isolation de grille est de 50 nm∼650 nm, et l'épaisseur de la troisième couche d'isolation de grille est de 20 nm∼600 nm.

9. Substrat matriciel selon l'une quelconque des revendications 1 à 8, dans lequel l'électrode de grille (402) et/ou les électrodes de source et de drain (406) sont des électrodes en cuivre ou alliage de cuivre.

10. Dispositif d'affichage, comprenant un substrat matriciel selon l'une quelconque des revendications 1 à 9.
